# EUROPEAN PATENT APPLICATION

(11) **EP 1 583 142 A2**
(43) Date of publication of application: **05.10.2005**
(21) Application number: 05007007.7
(22) Date of filing: 31.03.2005
(51) Int. Cl.: H01L 21/312, H01L 21/768

(54) **Deposition method and semiconductor device**

(30) Priority: 31.03.2004 JP 2004103466
(71) Applicant: SEMICONDUCTOR PROCESS LABORATORY CO., LTD., Chiba 272-0001 (JP)
(72) Inventor: Shioya, Yoshimi, 717-30 Futamata Ichikawa Chiba 272-0001 (JP); Shimoda, Haruo, 717-30 Futamata Ichikawa Chiba 272-0001 (JP); Maeda, Kazuo, 717-30 Futamata Ichikawa Chiba 272-0001 (JP)
(74) Representative: Schwabe - Sandmair - Marx

(57) **Abstract**

The present invention relates to a deposition method in which an insulating film that coats wirings mainly made of copper film and has low dielectric constant. Its constitution in the deposition method, where deposition gas is transformed into plasma and reaction is caused to form the insulating film having low dielectric constant, is that the deposition gas has a first silicon containing compound having cyclic siloxane bond and at least one of methyl group and methoxy group, and a second silicon containing organic compound having straight-chain siloxane bond and at least one of methyl group and methoxy group, as primary constituent gas.

## Description

### BACKGROUND OF THE INVENTION

### 1. Field of the Invention

The present invention relates to a deposition method and a semiconductor device, particularly to a deposition method for forming an insulating film that covers wirings mainly made of copper film and has low dielectric constant and a semiconductor device having the insulating film formed thereon.

### 2. Description of the Related Art

In recent years, higher data transfer speed has been required with higher integration and higher density of a semiconductor integrated circuit device, and a multilayer wiring structure with small RC delay time has been demanded. To achieve such multilayer wiring structure, wirings mainly made of copper having a small electric resistance are used as wirings, and an insulating film having a low dielectric constant (hereinafter, referred to as a low dielectric constant insulating film) is used as a barrier insulating film covering the wirings mainly made of copper and/or a primary insulating film on the barrier insulating film.

A deposition method by a coating method and a deposition method by a plasma-enhanced CVD method are known as a deposition method for forming the low dielectric constant insulating film. Although an insulating film deposited by the plasma-enhanced CVD method has a larger relative dielectric constant comparing to the insulating film deposited by the coating method, it has higher mechanical strength and smaller moisture content, so that research and development of a deposition method of the low dielectric constant insulating film by the plasma-enhanced CVD method has been diligently done.

Patent Documents 1, 2, 3 and the like, for example, describe the deposition method of the low dielectric constant insulating film such as the barrier insulating film and the primary insulating film on the barrier insulating film by the plasma-enhanced CVD method.
[Patent Document 1] Japanese Patent Laid-open No.2002-164346 publication
[Patent Document 2] Japanese Patent Laid-open No.2002-252228 publication
[Patent Document 3] Japanese Patent Laid-open No.2002-164429 publication

However, as higher driving frequency and data transfer speed have been demanded and wiring patterns become finer in recent years, formation of an interlayer insulating film having an even lower relative dielectric constant is necessary. For example, when the driving frequency exceeds GHz and the dimension of a wiring pattern becomes 65nm or less, the relative dielectric constant of 2.6 or less, preferably 2.4 or less, is necessary. In this case, it is necessary that the relative dielectric constant of the barrier insulating film covering copper be further reduced while maintaining a copper diffusion preventing function. In addition, a film having high mechanical strength despite a low relative dielectric constant is demanded.

### SUMMARY OF THE INVENTION

In the present invention, it is an object to provide a deposition method and a semiconductor device, where is capable of an improvement of mechanical strength, an improvement of their moisture absorbing characteristic, and an achievement of a lower dielectric constant in a barrier insulating film and/or a primary insulating film thereon, particularly regarding the barrier insulating film is capable of both a maintenance of the copper diffusion preventing function and further reduction of relative dielectric constant.

According to experiments conducted by the inventors of the present invention, in a method where deposition gas having silicon-containing organic compound as primary constituent gas or deposition gas having silicon-containing organic compound and oxidizing gas as primary constituent gas is transformed into plasma to deposit a low dielectric constant insulating film, when deposition is performed by using only cyclic siloxane having at least one of methyl group and methoxy group as the silicon containing organic compound, it results in obtaining only an insulating film which has a white turbidity, a low mechanical strength and high moisture absorbing characteristic despite a low relative dielectric constant. On the other hand, the inventors found out that when chain siloxane or organic silane having at least one of methyl group and methoxy group was added to the cyclic siloxane having at least one of methyl group and methoxy group, the white turbidity did not occur although the relative dielectric constant was increased corresponding to an added amount thereof. Consequently, it was made clear that the mechanical strength could be improved, the moisture absorbing characteristics could be improved and the relative dielectric constant could be maintained low by adjusting the flow rate of chain siloxane or organic siloxane to cyclic siloxane. Further, it was made clear that the film also had the copper diffusion preventing function. Particularly, it was made clear that the use of siloxane or organic silane containing methoxy group was effective in increasing the mechanical strength.

In the present invention, deposition is performed by a plasma-enhanced CVD method using a deposition gas having a gas mixture of the cyclic siloxane having at least one of methyl group and methoxy group and the chain siloxane having at least one of methyl group and methoxy group as a primary constituent gas. Alternatively, deposition is performed by a plasma-enhanced CVD method using a deposition gas having a gas mixture of the cyclic siloxane having at least one of methyl group and methoxy group and the organic silane having at least one of methyl group and methoxy group as a primary constituent gas. Alternatively, deposition is performed by a plasma-enhanced CVD method using a deposition gas where oxidizing gas such as H₂O is further added to the gas mixture.

It results in prevention of the white turbidity of an insulating film (formed film) to be formed and maintenance of the high mechanical strength, and further it results in improvement of the moisture absorbing characteristics of the formed film and reduction of the relative dielectric constant of the formed film to 2.6 or less. Further, it is possible to allow the insulating film to have the copper diffusion preventing function, additionally.

In this case, by adding methyl alcohol or ethyl alcohol to the above-described gas combination, CH₃, C₂H₅ or the like is taken in the formed film to further reduce the relative dielectric constant and bridge reaction in the formed film is enhanced by oxidation due to OH group to further increase the mechanical strength of the formed film.

Additionally, by adding inert gas as diluting gas to the above-described deposition gas, rapid reaction of deposition gas can be suppressed and vapor phase reaction can be suppressed. This prevents the reduction of the mechanical strength and adhesion strength of the formed film, and also prevents the generation of particles. Note that it is preferable to add an inert gas by an appropriate amount because too much addition of the inert gas results in increase of the relative dielectric constant.

In this case, this deposition method is applied for a semiconductor device in which copper wirings and the like are formed. And the insulating film having the above-described characteristic is used as a barrier insulating film covering the copper wirings and the like, as an insulating film directly covering the copper wirings and the like, or as a primary insulating film on the barrier insulating film covering the copper wirings and the like. And the above-described insulating film or the barrier insulating film and the primary insulating film are used as an insulating film that constitutes a wiring interlayer insulating film or a wiring buried insulating film. Thus, high-speed performance of the semiconductor device can be improved.

### BRIEF DESCRIPTION OF THE DRAWINGS

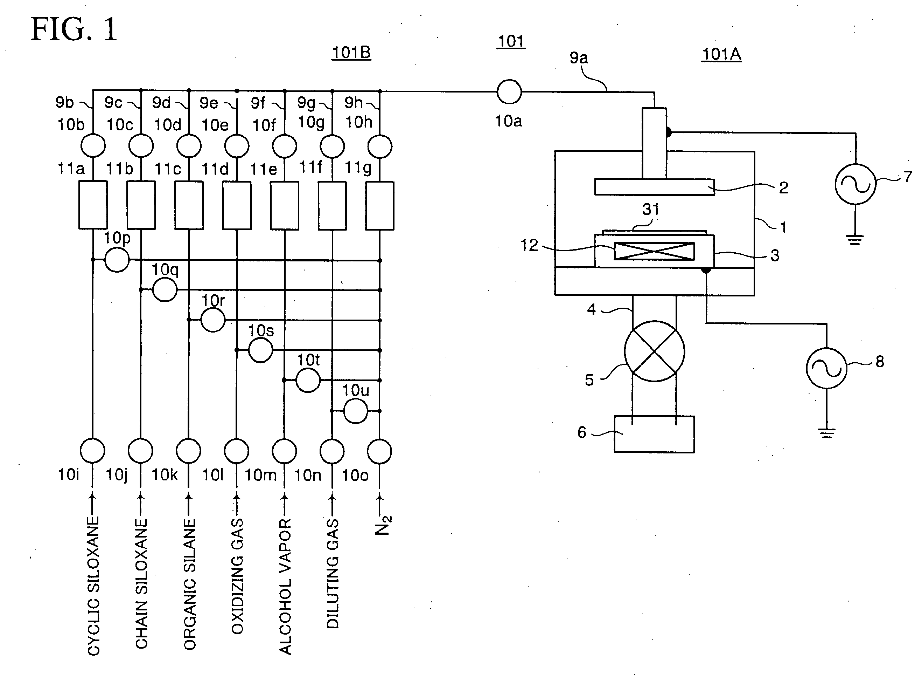

Fig. 1 is a side view showing a constitution of a plasma-enhanced CVD deposition apparatus used in a deposition method that is a first embodiment of the present invention.

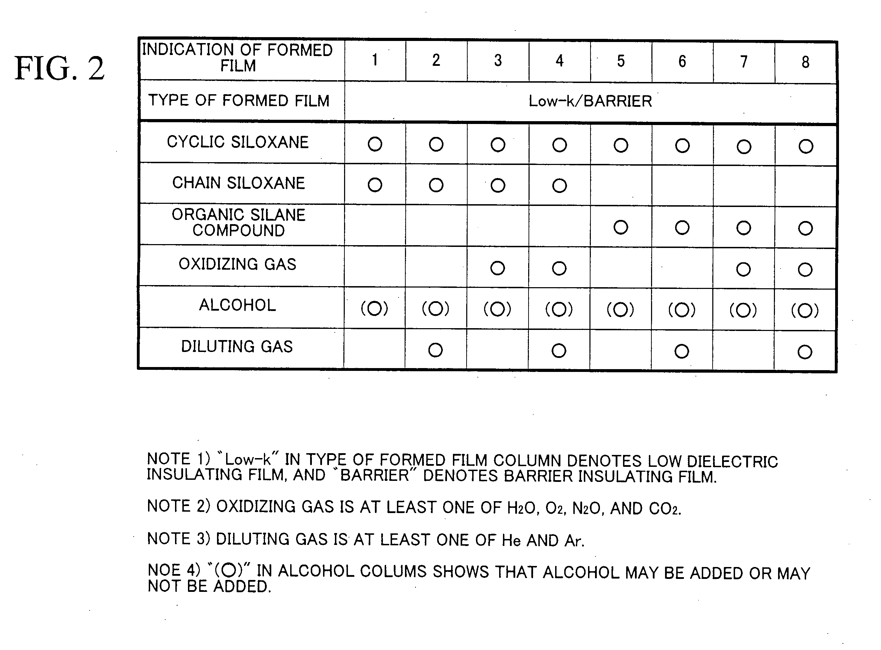

Fig. 2 is a table showing combinations of constituent gases in deposition gas used in the deposition method that is the first embodiment of the present invention.

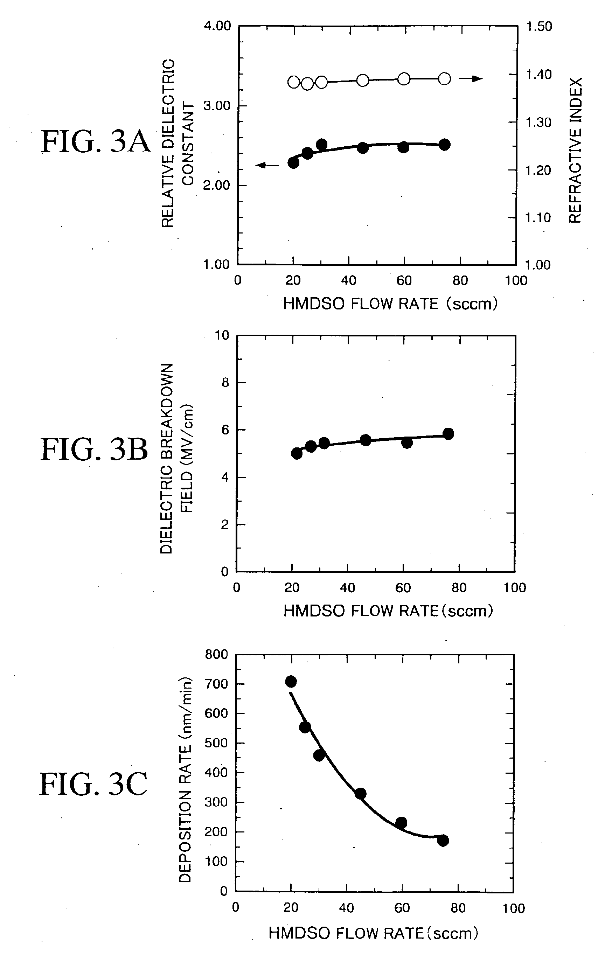

Figs. 3A, 3B, 3C are graphs showing the relationship of a relative dielectric constant, a dielectric breakdown field, and a deposition rate with respect to an HMDSO flow rate regarding an insulating film formed under deposition conditions I by the deposition method that is the first embodiment of the present invention.

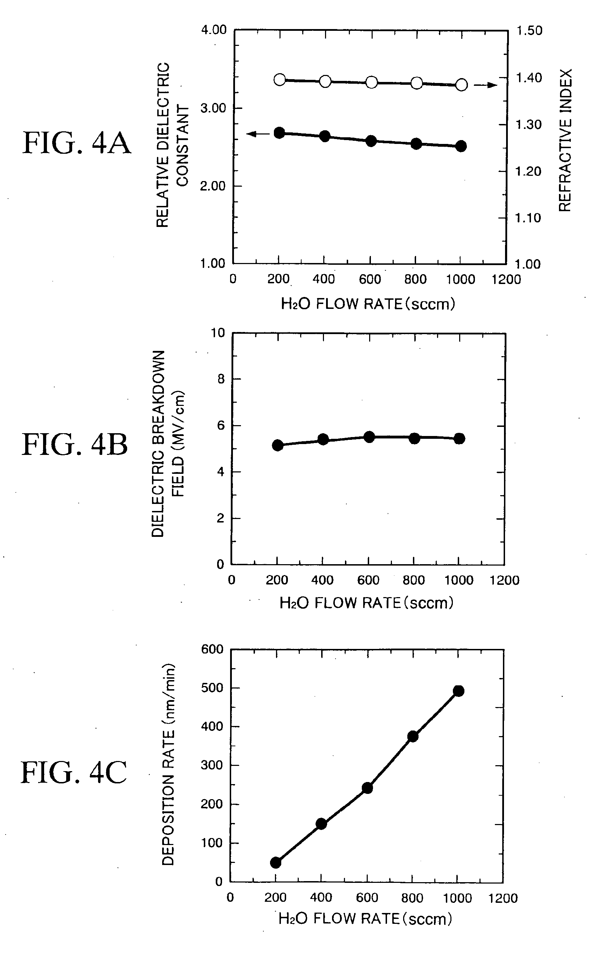

Figs. 4A, 4B, 4C are graphs showing the relationship of the relative dielectric constant, the dielectric breakdown field, and the deposition rate with respect to an H₂O flow rate regarding the insulating film formed under deposition conditions I by the deposition method that is the first embodiment of the present invention.

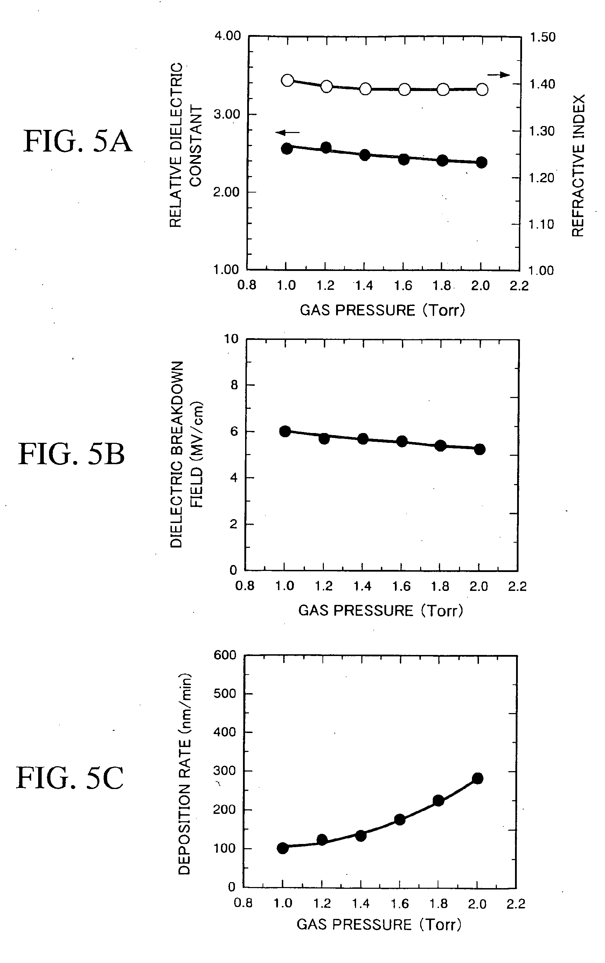

Figs. 5A, 5B, 5C are graphs showing the relationship of the relative dielectric constant, the dielectric breakdown field, and the deposition rate with respect to a gas pressure regarding the insulating film formed under deposition conditions I by the deposition method that is the first embodiment of the present invention.

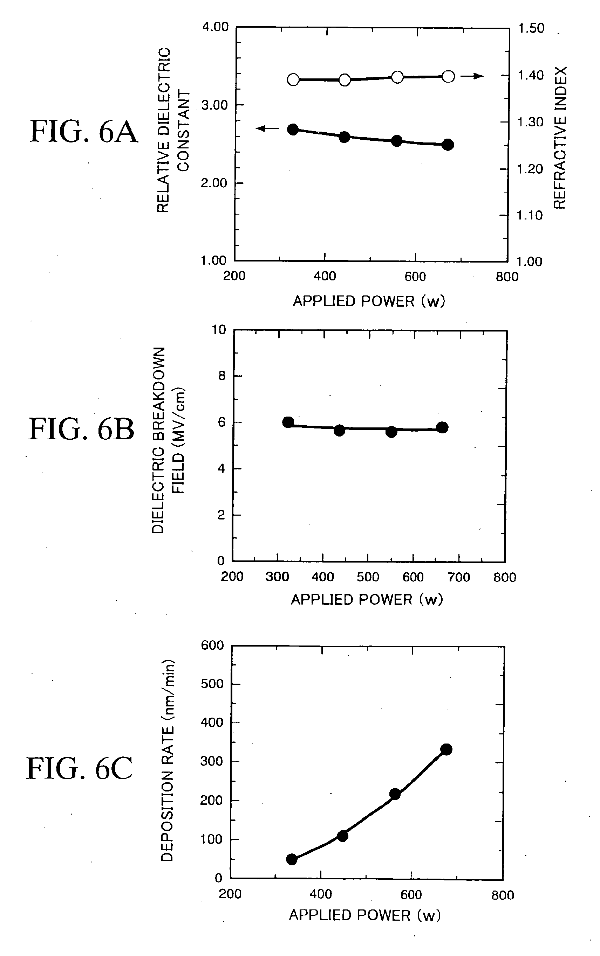

Figs. 6A, 6B, 6C are graphs showing the relationship of the relative dielectric constant, the dielectric breakdown field, and the deposition rate with respect to an applied electric power regarding the insulating film formed under deposition conditions I by the deposition method that is the first embodiment of the present invention.

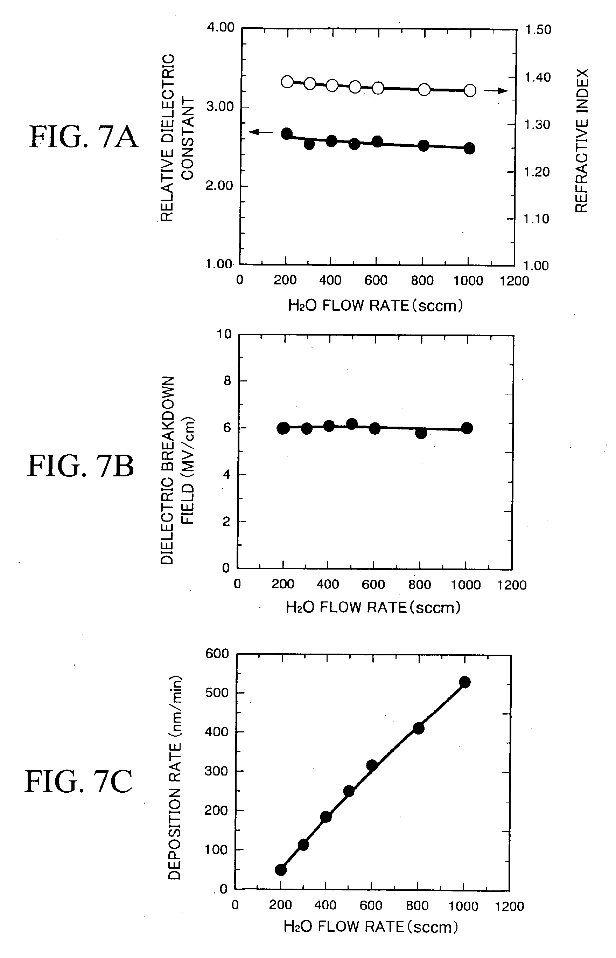

Figs. 7A, 7B, 7C are graphs showing the relationship of the relative dielectric constant, the dielectric breakdown field, and the deposition rate with respect to an H₂O flow rate regarding an insulating film formed under deposition conditions II by the deposition method that is the first embodiment of the present invention.

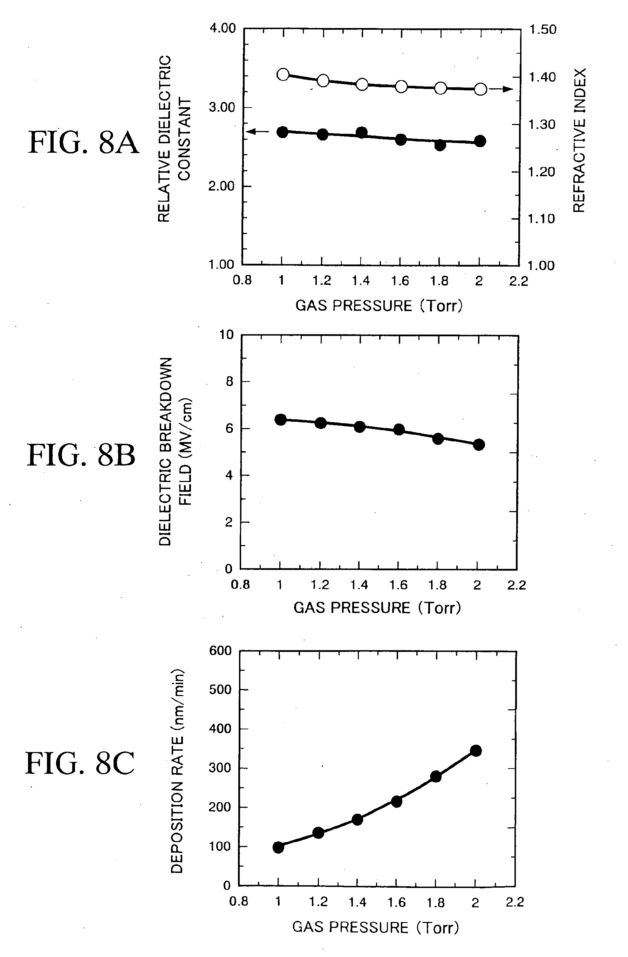

Figs. 8A, 8B, 8C are graphs showing the relationship of the relative dielectric constant, the dielectric breakdown field, and the deposition rate with respect to a gas pressure regarding the insulating film formed under deposition conditions II by the deposition method that is the first embodiment of the present invention.

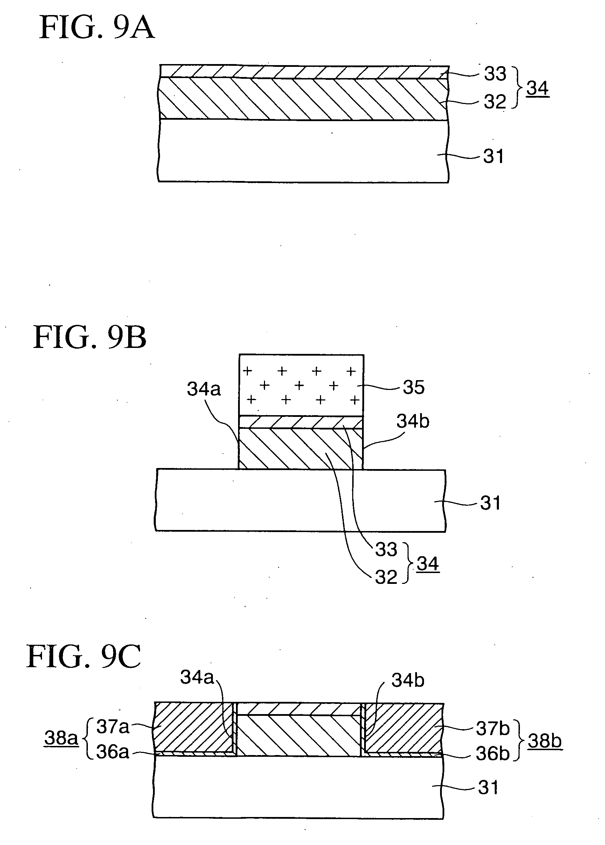

Figs. 9A to 9G are sectional views showing a semiconductor device that is a second embodiment of the present invention and its manufacturing method.

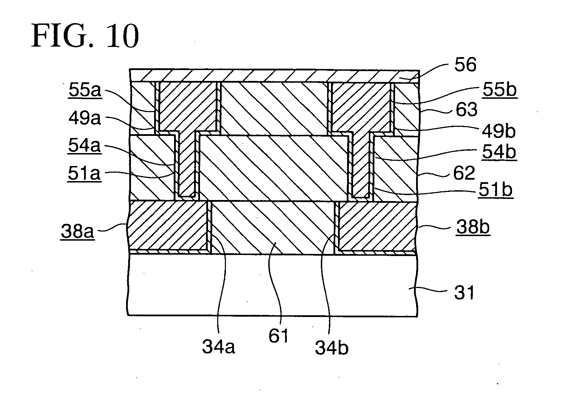

Fig. 10 is sectional views showing a semiconductor device that is a third embodiment of the present invention and its manufacturing method.

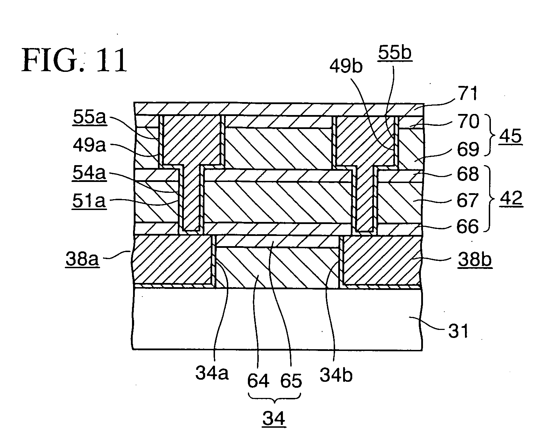

Fig. 11 is sectional views showing a semiconductor device that is a fourth embodiment of the present invention and its manufacturing method.

### DETAILED DESCRIPTION OF THE PREFERRED EMBODIMENTS

Embodiments of the present invention will be explained with reference to the drawings hereinafter.

### (First Embodiment)

Fig. 1 is the side view showing the constitution of a parallel plate type plasma deposition apparatus 101 used in the deposition method according to the embodiments of the present invention.

The parallel plate type plasma-enhanced CVD deposition apparatus 101 is made up of a deposition section 101A, which is a place of forming the insulating film on a substrate 21 subject to deposition by plasma gas, and a deposition gas supply section 101B having supply sources of a plurality of gases that constitute the deposition gas.

The deposition section 101A, as shown in Fig. 1, comprises a chamber 1 in which pressure can be reduced, where the chamber 1 is connected to an exhaust unit 6 via an exhaust pipe 4. An opening/closing valve 5 that controls communication/non-communication between the chamber 1 and the exhaust unit 6 is provided halfway the exhaust pipe 4. The chamber 1 is provided with pressure measurement means such as a vacuum meter (not shown) for monitoring the pressure inside the chamber 1.

The chamber 1 is provided with a pair of an upper electrode (first electrode) 2 and a lower electrode (second electrode) 3 which oppose to each other. A high-frequency power supply source (RF power source) 7, which supplies high-frequency power having the frequency of 13.56 MHz, is connected to the upper electrode 2, and a low-frequency power supply source 8, which supplies low-frequency power having the frequency of 380 kHz, is connected to the lower electrode 3. The power supply sources 7, 8 supply power to the upper electrode 2 and the lower electrode 3, and thus the deposition gas is transformed into plasma. The upper electrode 2, the lower electrode 3, and the power sources 7, 8 constitute plasma generation means that transforms the deposition gas into plasma.

The upper electrode 2 serves as a distributor of the deposition gas. A plurality of through holes are formed in the upper electrode 2, and openings of the through holes at the opposing surface to the lower electrode 3 are discharge ports (introduction ports) of the deposition gas. The discharge ports of the deposition gas or the like is connected to the deposition gas supply section 101B via piping 9a. Alternatively, there are cases where the upper electrode 2 is provided with a heater (not shown) depending on circumstances. The heater is used to heat the upper electrode 2 to the temperature of about 100°C to 200°C during deposition to prevent particles made of reactive products of the deposition gas or the like from adhering to the upper electrode 2.

The lower electrode 3 serves as a holding stage for the substrate 21 subject to deposition, and is provided with a heater 12 heating the substrate 21 subject to deposition on the holding stage.

The deposition gas supply section 101B is provided with a supply source of cyclic siloxane (first silicon containing organic compound) having at least one of methyl group and methoxy group, a supply source of chain siloxane (second silicon containing organic compound) having at least one of methyl group and methoxy group, a supply source of organic silane where at least one of methyl group and methoxy group has bonded silicon, a supply source of oxidizing gas made of any one of H₂O, O₂, N₂O and CO₂, a supply source of alcohol such as methyl alcohol (CH₃OH) and ethyl alcohol (C₂H₅OH), a supply source of diluting gas, and a supply source of nitrogen (N₂).

The gases are accordingly supplied into the chamber 1 through branch piping (9b to 9h) and piping 9a to which all the branch piping (9b to 9h) are connected. Flow rate adjusting means (11a to 11g) and opening/closing means (10b to 10o) for controlling communication/non-communication of the branch piping (9b to 9h) are installed halfway the branch piping (9b to 9h), and opening/closing means 10a for opening/closing the piping 9a is installed halfway the piping 9a.

Further, to purge residual gas in the branch piping (9b to 9g) by allowing N₂ gas to circulate, opening/closing means (10p to 10u) for controlling communication/non-communication between the branch piping 9h connected to the supply source of N₂ gas and the other branch piping (9b to 9g) are installed. Note that N₂ gas purges not only the residual gas in the branch piping (9b to 9b) but also the residual gas in the piping 9a and the chamber 1. In addition, there are cases where N₂ gas is used as diluting gas.

According to the above-described deposition apparatus 101, it comprises the supply source of cyclic siloxane, the supply source of chain siloxane, the supply source of organic silane, the supply source of oxidizing gas, the supply source of alcohol, and the supply source of diluting gas, and also comprises plasma generation means (2, 3, 7, 8) that transform the deposition gas into plasma.

With this configuration, it is possible to form a barrier insulating film or a low dielectric constant insulating film, where the mechanical strength is improved, the moisture absorbing characteristic is improved, and the relative dielectric constant is reduced to 2.6 or less while the copper diffusion preventing function is maintained, as shown in the examples below.

Then, there exists means for generating plasma by the upper electrode 2 and the lower electrode 3 of the parallel plate type, for example, as the plasma generation means. The upper electrode 2 and the lower electrode 3 are subject to respective connections of the power supply sources (7, 8) that supply electric powers having two frequencies of high and low to the upper electrode 2 and the lower electrode 3, respectively. Therefore, the electric powers having two frequencies of high and low are respectively applied to respective electrodes (2,3) and thus plasma can be generated. Of these, at least the insulating film formed by applying low frequency electric power is much denser. At least the insulating film formed by applying high-frequency electric power has an even lower relative dielectric constant.

Next, the following gases can be used as representative examples regarding the deposition gas used in the present invention, which are the first silicon containing organic compound having cyclic siloxane bond and at least one of methyl group and methoxy group, the second silicon containing organic compound having straight-chain siloxane bond and at least one of methyl group and methoxy group, organic silane having at least one of methyl group and methoxy group, oxidizing gas, alcohol, and diluting gas.

### (i) The first silicon containing organic compound having cyclic siloxane bond and at least one of methyl group and methoxy group

The followings are examples of cyclic siloxane.

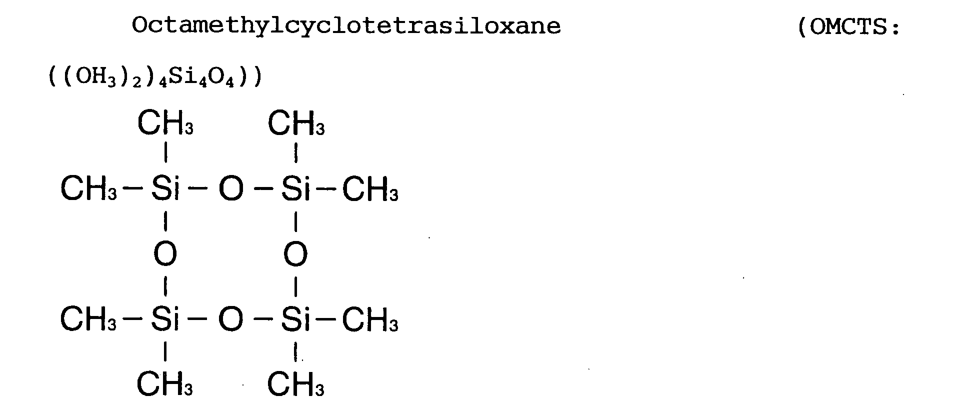

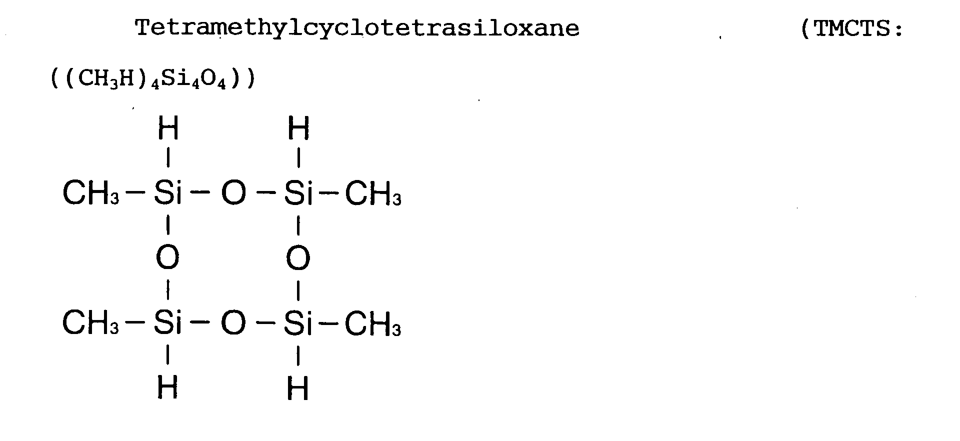

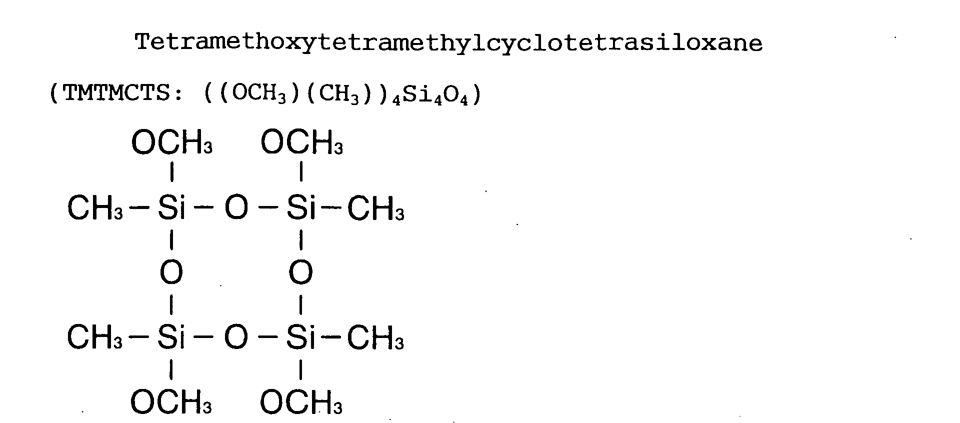

### (ii) The second silicon containing organic compound having straight-chain siloxane bond and at least one of methyl group and methoxy group

The followings are examples of chain siloxane.

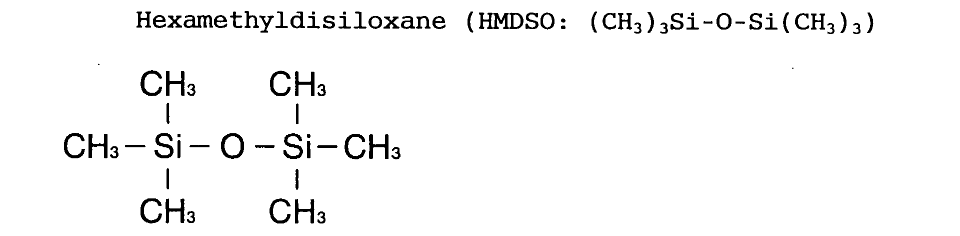

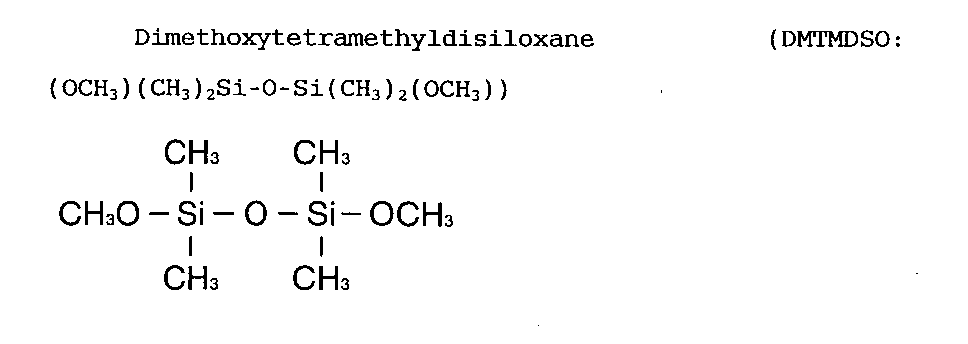

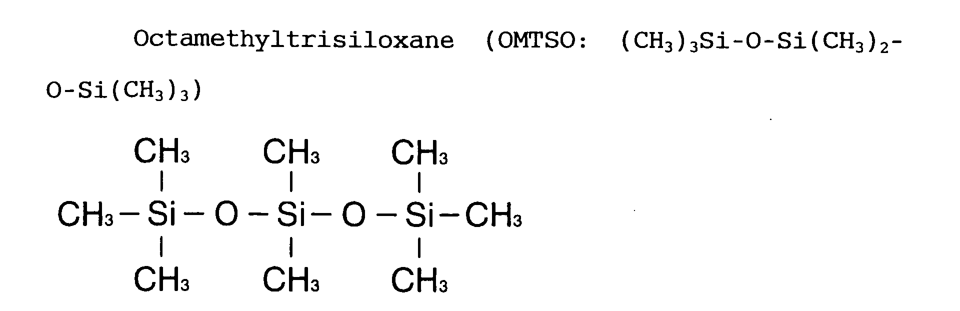

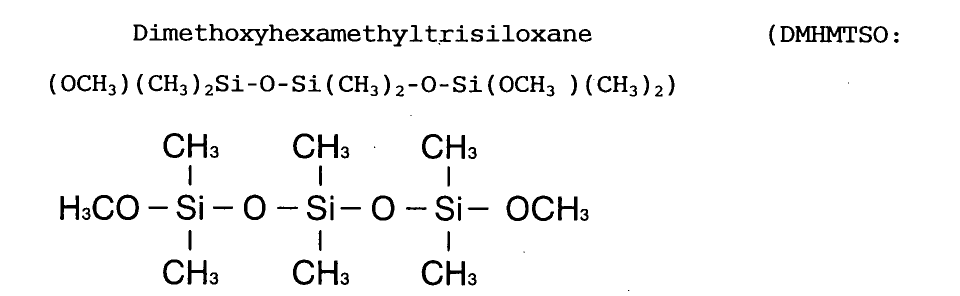

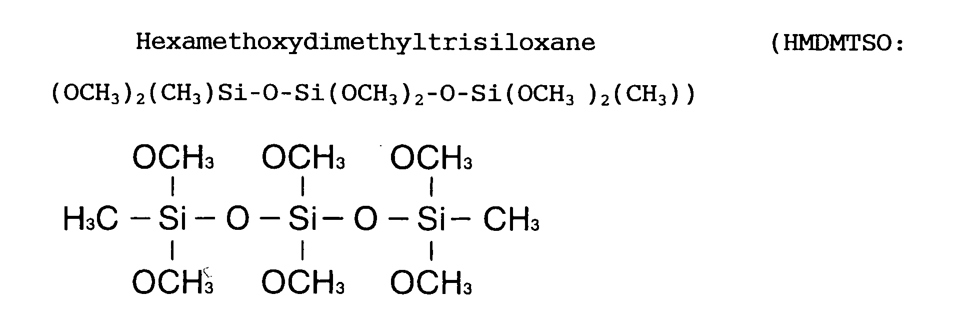

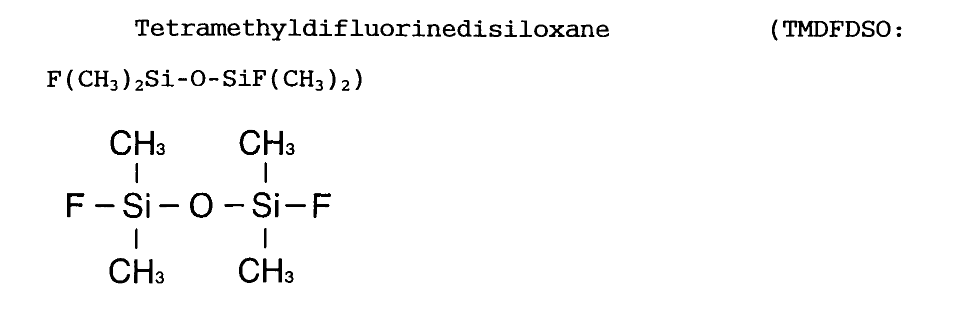

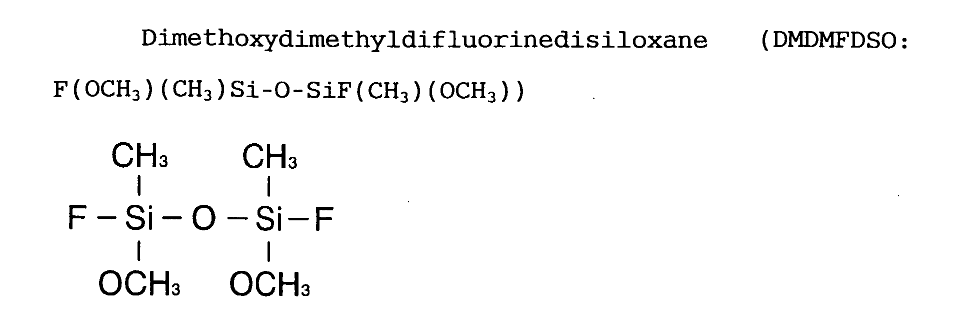

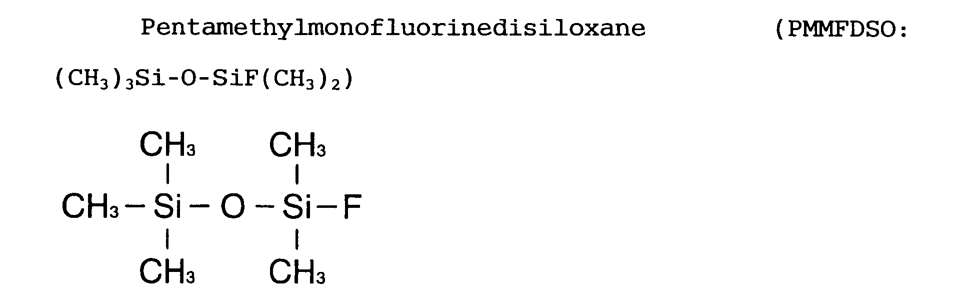

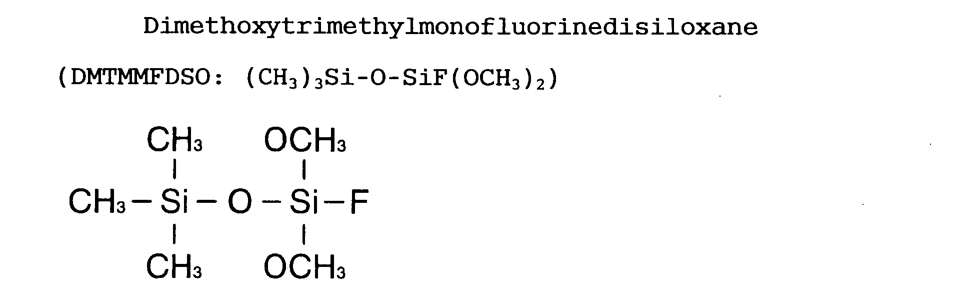

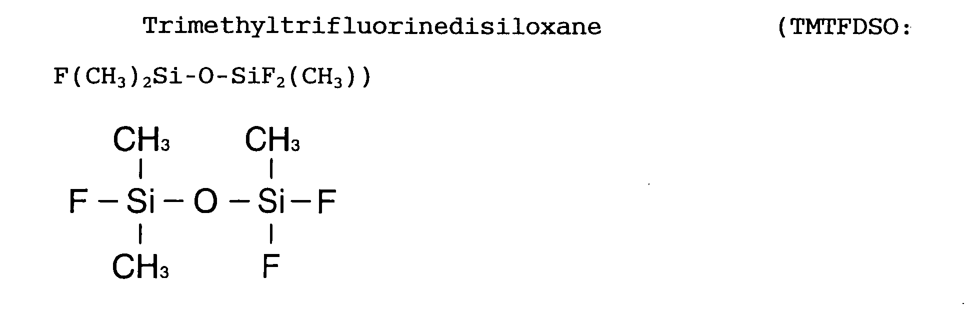

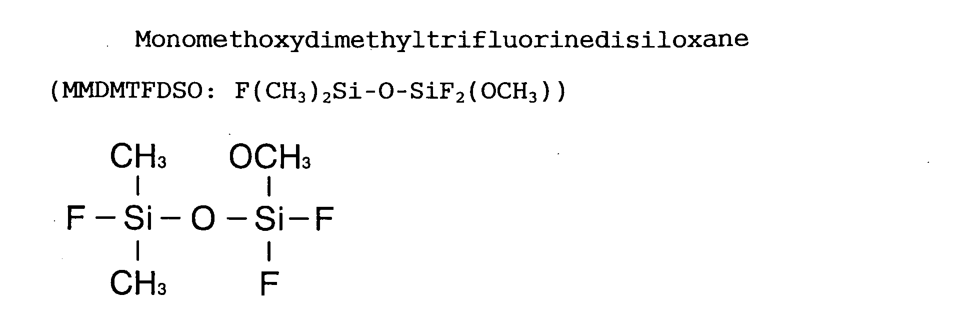

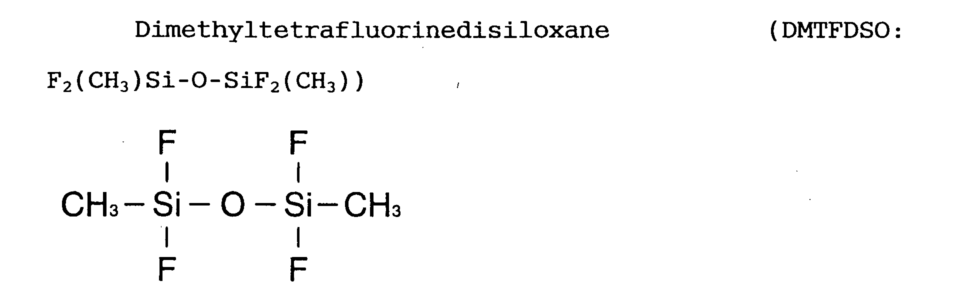

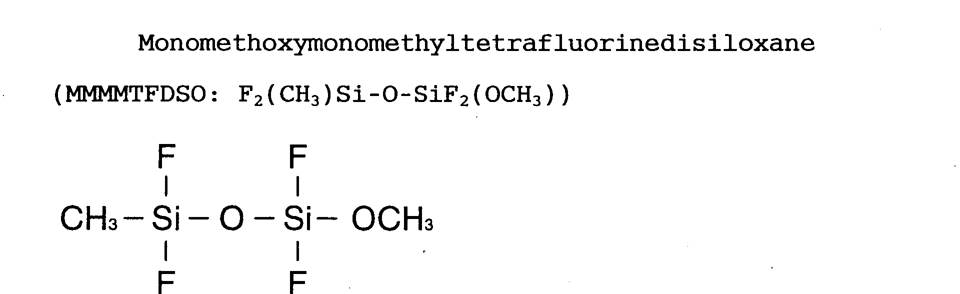

### (iii) Organic silane having at least one of methyl group and methoxy group

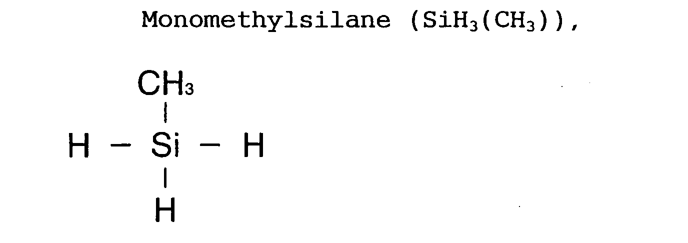

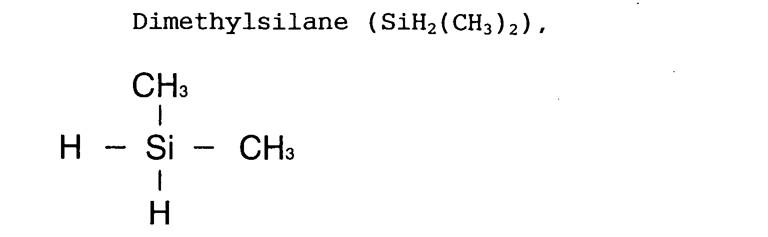

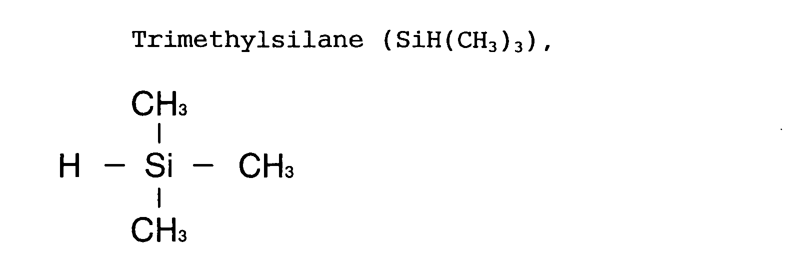

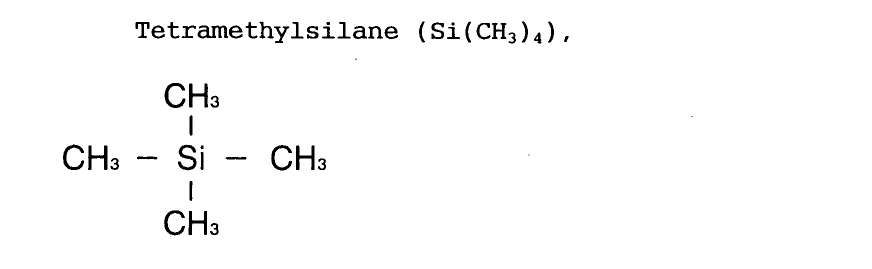

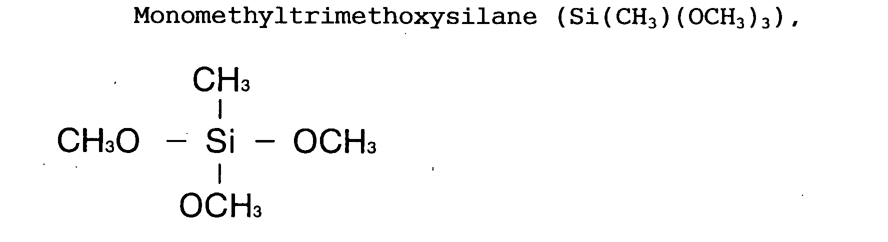

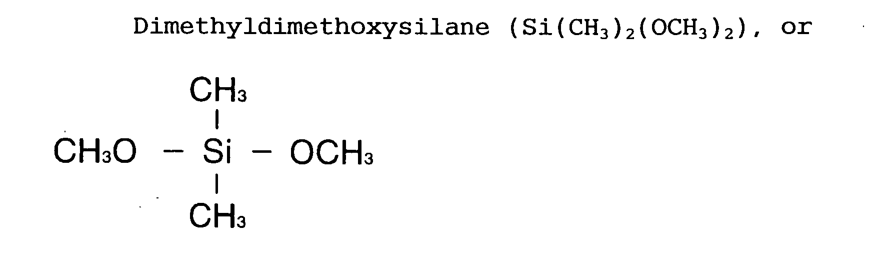

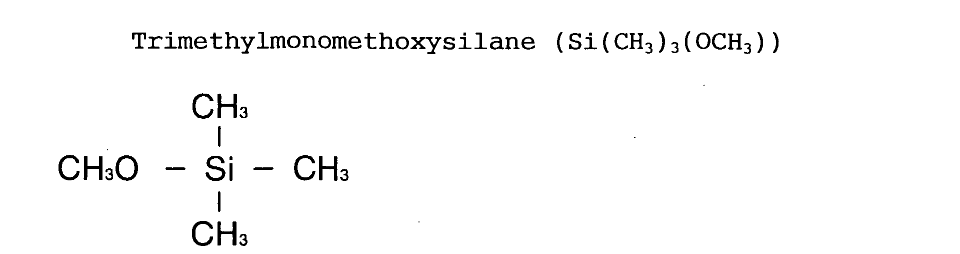

### (iv) Oxidizing gas

Oxygen (O₂)
Water (H₂O)
Nitrogen monoxide (N₂O)
Carbon dioxide gas (CO₂)

### (v) Alcohol

Methyl alcohol (CH₃OH)
Ethyl alcohol (C₂H₅OH)

Note that alcohol is vaporized in room temperature or by heating, and used in a gaseous state.

### (vi) Diluting gas

Helium (He)
Argon (Ar)
Nitrogen (N₂)

Significance of using the above-described gases will be described as follows.

According to the experiments conducted by the inventors of the present invention, the followings were made clear in the deposition method of the low dielectric constant insulating film by transforming into plasma the deposition gas which contains the primary constituent gas composing of the silicon containing organic compound, or of the silicon containing organic compound and the oxidizing gas.

Specifically, when deposition is performed by using only cyclic siloxane having at least one of methyl group and methoxy group as the silicon containing organic compound, it results in formation of only an insulating film which shows white turbidity, is low in mechanical strength, and is high in moisture absorbing characteristic despite a low relative dielectric constant. On the other hand, when chain siloxane or organic silane having at least one of methyl group and methoxy group is added to the cyclic siloxane having at least one of methyl group and methoxy group, white turbidity does not occur although the relative dielectric constant increases corresponding to an added amount thereof.

After conducting such experiment for several times, it was made clear that when adjusting the amount of chain siloxane or organic siloxane to be added to cyclic siloxane, it led to improvement of the mechanical strength, improvement of the moisture absorbing characteristics, and maintenance of the low relative dielectric constant. Further, it was also made clear that it led to a grant of the copper diffusion preventing function to the formed film.

Particularly, it was made clear that the use of siloxane or organic silane containing methoxy group was effective regarding improvement of the mechanical strength.

Furthermore, it was made clear that use of compound containing fluorine (F) led to further reduction of the relative dielectric constant and further improvement of the mechanical strength.

In this case, CH₃, C₂H₅ or the like is taken in the formed film to further reduce the relative dielectric constant by further adding methyl alcohol or ethyl alcohol to the above combination of gases, and bridge reaction in the formed film is enhanced by oxidation due to OH group, and thus the mechanical strength can be further increased.

Additionally, an addition of inert gas results in suppression of rapid reaction of deposition gas and thus in suppression of vapor phase reaction. If the vapor phase reaction occurs, the film quality of the formed film deteriorates drastically. For example, the mechanical strength or the adhesion strength of the formed film deteriorates. Moreover, it causes generation of particles, which is not preferable. Such problems can be prevented by suppressing the vapor phase reaction. Note that it is preferable to add an appropriate amount of inert gas because too much addition of inert gas results in a higher relative dielectric constant.

Next, combinations of constituent gases in the deposition gas will be explained referring to Fig. 2. Possible combinations are as follows. Each combination is one deposition gas, and can be used in the present invention.
(1-a) First silicon containing organic compound / Second silicon containing organic compound
(1-b) First silicon containing organic compound / Second silicon containing organic compound / Alcohol
(2-a) First silicon containing organic compound / Second silicon containing organic compound / Diluting gas
(2-b) First silicon containing organic compound / Second silicon containing organic compound / Diluting gas / Alcohol
(3-a) First silicon containing organic compound / Second silicon containing organic compound / Oxidizing gas
(3-b) First silicon containing organic compound / Second silicon containing organic compound / Oxidizing gas / Alcohol
(4-a) First silicon containing organic compound / Second silicon containing organic compound / Oxidizing gas / Diluting gas
(4-b) First silicon containing organic compound / Second silicon containing organic compound / Oxidizing gas / Diluting gas / Alcohol
(5-a) First silicon containing organic compound / Organic silane
(5-b) First silicon containing organic compound / Organic silane /Alcohol
(6-a) First silicon containing organic compound / Organic silane / Diluting gas
(6-b) First silicon containing organic compound / Organic silane / Diluting gas / Alcohol
(7-a) First silicon containing organic compound / Organic silane / Oxidizing gas
(7-b) First silicon containing organic compound / Organic silane / Oxidizing gas / Alcohol
(8-a) First silicon containing organic compound / Organic silane / Oxidizing gas / Diluting gas
(8-b) First silicon containing organic compound / Organic silane / Oxidizing gas / Diluting gas / Alcohol

Next, deposition experiments conducted by the inventors of the present invention will be explained.

A silicon oxide film was deposited on an Si substrate by a plasma enhanced CVD method (PECVD method) under the following deposition condition I. The deposition gas falls under the combination of 4-a described above. Specifically, OMCTS was used as the first silicon containing organic compound, HMDSO was used as the second silicon containing organic compound, H₂O was used as the oxidizing gas, and He was used as the diluting gas.

In the deposition, 1 minute and 30 seconds were taken for time (stabilizing period) required in displacing gas inside the chamber from gas introduction to deposition start (plasma excitation), and the upper electrode 2 is heated at 100°C to prevent reactive products from adhering to the upper electrode 2.

### Deposition condition I

Deposition gas
   OMCTS flow rate: 75 sccm
   HMDSO flow rate: 75 sccm
   H₂O flow rate: 500 sccm
   He flow rate: 100 sccm
   Gas pressure: 1.7 Torr
Plasma excitation condition
   Upper electrode (fist electrode)
      High-frequency power (frequency: 13.56 MHz): 562W (equivalent to about 0.6W/cm²)
   Lower electrode (second electrode)
      Low-frequency power (380 KHz): 0W
Substrate heating condition: 350°C

Figs. 3A to 3C show results of data acquisition when the deposition condition other than the HMDSO flow rate were fixed as shown in the deposition condition I and the HMDSO flow rate was changed within the range of 20 to 80 sccm. Further, Figs. 4A to 4C show results of data acquisition when the deposition condition other than the H₂O flow rate were fixed as shown in the deposition condition I and the H₂O flow rate was changed within the range of 200 to 1000 sccm. Furthermore, Figs. 5A to 5C show results of data acquisition when the deposition condition other than the gas pressure were fixed as shown in the deposition condition I and the gas pressure was changed within the range of 1.0 to 2.0 Torr. Still further, Figs. 6A to 6C show results of data acquisition when the deposition condition other than the high-frequency power (frequency: 13.56 MHz) were fixed as shown in the deposition condition I and the high-frequency power (frequency: 13.56 MHz) was changed within the range of 350 to 650W.

### (i) Relationship between the HMDSO flow rate of deposition gas and the relative dielectric constant, the dielectric breakdown field, the deposition rate of an insulating film formed on an Si substrate

### (a) Relationship between the HMDSO flow rate of deposition gas and the relative dielectric constant of the formed film

Fig. 3A is the view showing the relationship between the HMDSO flow rate of the deposition gas and the relative dielectric constant and the refraction index of the formed film. The left axis of ordinate denotes the relative dielectric constant of the formed film expressed in linear scale, the right axis of ordinate denotes the refraction index of the formed film expressed in linear scale, and the axis of abscissas denotes the HMDSO flow rate (sccm) expressed in linear scale.

According to Fig. 3A, the relative dielectric constant of the formed film gradually increases with the change of the HMDSO flow rate. The relative dielectric constant of about 2.25 when the HMDSO flow rate was 20 sccm became about 2.55 when the HMDSO flow rate was 30 sccm, it maintained an approximately constant value after that, and became about 2.55 when the HMDSO flow rate was 80 sccm.

The low value of relative dielectric constant of 2.6 or less was obtained in the total survey range of the HMDSO flow rate from 20 to 80 sccm.

Note that the refraction index is shown as a guidepost for the density of the formed film. The higher the refraction index, the denser the film. The same applies to the followings and its explanation will be omitted.

### (b) Relationship between the HMDSO flow rate of deposition gas and the dielectric breakdown field of the formed film

Fig. 3B is the view showing the relationship between the HMDSO flow rate of the deposition gas and the dielectric breakdown field of the formed film. The axis of ordinate shows the dielectric breakdown field (MV/cm) of the formed film expressed in linear scale, and the axis of abscissas shows the HMDSO flow rate (sccm) expressed in linear scale.

According to Fig. 3B, the dielectric breakdown field gradually increases with the change of the HMDSO flow rate, and it became 5MV/cm or more in the total survey range of the HMDSO flow rate from 20 to 80 sccm. It was made clear that the film had sufficient dielectric breakdown voltage as the barrier insulating film.

### (c) Relationship between the HMDSO flow rate of deposition gas and the deposition rate of the formed film

Fig. 3C is the view showing the relationship between the HMDSO flow rate of the deposition gas and the deposition rate of the formed film. The axis of ordinate shows the deposition rate (nm/min) of the formed film expressed in linear scale, and the axis of abscissas shows the HMDSO flow rate (sccm) expressed in linear scale.

According to Fig. 3C, the deposition rate decreases in inverse proportion to the increase of the HMDSO flow rate. The deposition rate was about 700nm/min at the HMDSO flow rate of 20 sccm, and it was about 70nm/min at the flow rate of 80 sccm. It was found out that a practical level (presumably about 300nm/min) was at a small HMDSO flow rate.

### (ii) Relationship between the H₂O flow rate of deposition gas and the relative dielectric constant, the dielectric breakdown field, the deposition rate of an insulating film formed on an Si substrate

### (a) Relationship between the H₂O flow rate of deposition gas and the relative dielectric constant of the formed film

Fig. 4A is the view showing the relationship between the H₂O flow rate of the deposition gas and the relative dielectric constant and the refraction index of the formed film. The left axis of ordinate denotes the relative dielectric constant of the formed film expressed in linear scale, the right axis of ordinate denotes the refraction index of the formed film expressed in linear scale, and the axis of abscissas denotes the H₂O flow rate (sccm) expressed in linear scale.

According to Fig. 4A, the relative dielectric constant of the formed film gradually decreases with the change of the H₂O flow rate. The relative dielectric constant of about 2.65 when the H₂O flow rate was 200 sccm became about 2.55 when the H₂O flow rate was 1000 sccm. The low value of relative dielectric constant of 2.6 or less was obtained in the range of the H₂O flow rate from about 500 to 1000 sccm.

### (b) Relationship between the H₂O flow rate of deposition gas and the dielectric breakdown field of the formed film

Fig. 4B is the view showing the relationship between the H₂O flow rate of deposition gas and the dielectric breakdown field of the formed film. The axis of ordinate shows the dielectric breakdown field (MV/cm) of the formed film expressed in linear scale, and the axis or abscissas shows the H₂O flow rate (sccm) expressed in linear scale. An insulating film to be surveyed was formed on a copper film and the dielectric breakdown field was measured by using the copper film as one electrode. The same applies to the following measurement of dielectric breakdown field.

According to Fig. 4B, the field gradually increased with the change of H₂O flow rate, and it became 5MV/cm or more in the total survey range of the H₂O flow rate from 200 to 1000 sccm. It was made clear that the film had sufficient dielectric breakdown voltage as the barrier insulating film. This shows that the insulating film has sufficient copper diffusion preventing function.

### (c) Relationship between the H₂O flow rate of deposition gas and the deposition rate of a formed film

Fig. 4C is the view showing the relationship between the H₂O flow rate of deposition gas and the deposition rate of the formed film. The axis of ordinate shows the deposition rate (nm/min) of the formed film expressed in linear scale, and the axis or abscissas show the H₂O flow rate (sccm) expressed in linear scale.

According to Fig. 4C, the deposition rate showed substantially monotonic increase in proportion with the increase of the H₂O flow rate. The deposition rate was about 30nm/min at the H₂O flow rate of 200 sccm, and was about 500nm/min at the rate of 1000 sccm. It was found out that a practical level was at a large H₂O flow rate.

### (iii) Relationship between the gas pressure of deposition gas and the relative dielectric constant, the dielectric breakdown field, and the deposition rate of a formed film

### (a) Relationship between the gas pressure of deposition gas and the relative dielectric constant of an insulating film formed on an Si substrate

Fig.5A is the view showing the relationship between the gas pressure of the deposition gas and the relative dielectric constant and the refraction index of the formed film. The left axis of ordinate denotes the relative dielectric constant of the formed film expressed in linear scale, the right axis of ordinate denotes the refraction index of the formed film expressed in linear scale, and the axis of abscissas denotes the gas pressure (Torr) expressed in linear scale.

According to Fig. 5A, the changes of the relative dielectric constant of the formed film is small with respect to the changes of the gas pressure, and the relative dielectric constant of the formed film gradually decreases in inverse proportion to the increase of gas pressure. The relative dielectric constant of the formed film was 2.6 at the gas pressure of 1.0 Torr and 2.4 at 2.0 Torr.

As described, the low value of the relative dielectric constant of 2.6 or less was obtained in the total survey range of the gas pressure from 1.0 to 2.0 Torr.

### (b) Relationship between the gas pressure of deposition gas and the dielectric breakdown field of the formed film

Fig. 5B is the view showing the relationship between the gas pressure of deposition gas and the dielectric breakdown field of the formed film. The axis of ordinate denotes the dielectric breakdown field (MV/cm) of the formed film expressed in linear scale, and the axis of abscissas denotes the gas pressure (Torr) expressed in linear scale.

According to Fig. 5B, the changes of the dielectric breakdown field of the formed film is small with respect to the changes of the gas pressure, and the dielectric breakdown field of the formed film gradually decreases in inverse proportion to the increase of the gas pressure. The dielectric breakdown field of the formed film was 6MV/cm at the gas pressure of 1.0 Torr, and about 5.2MV/cm at 2.0 Torr.

As described above, the field became 5MV/cm or more in the total survey range of the gas pressure from 1.0 to 2.0 Torr. It was made clear that the film had sufficient dielectric breakdown voltage as the barrier insulating film.

### (c) Relationship between the gas pressure of deposition gas and the deposition rate of the formed film

Fig. 5C is the view showing the relationship between the gas pressure of deposition gas and the deposition rate of the formed film. The axis of ordinate denotes the deposition rate (nm/min) of the formed film expressed in linear scale, and the axis of abscissas denotes the gas pressure (Torr) of deposition gas expressed in linear scale.

According to Fig. 5C, the deposition rate increases in proportion to the increase of the gas pressure. The deposition rate was 100nm/min at the gas pressure of 1.0 Torr and 290nm/min at the gas pressure of 2.0 Torr. The values may be a little too low as a practical level.

### (iv) Relationship between the high-frequency power (frequency: 13.56 MHz) applied to deposition gas and the relative dielectric constant, the dielectric breakdown field, and the deposition rate of an insulating film formed on Si substrate

### (a) Relationship between the high-frequency power (frequency: 13.56 MHz) and the relative dielectric constant of the formed film

Fig. 6A is the view showing the relationship between the high-frequency power to transform deposition gas into plasma and the relative dielectric constant and the refraction index of the formed film. The left axis of ordinate denotes the relative dielectric constant of the formed film expressed in linear scale, the right axis of ordinate denotes the refraction index of the formed film expressed in linear scale, and the axis of abscissas denotes the high-frequency power (W) expressed in linear scale. Note that an electrode of 340mmφ is used as an electrode to which high-frequency power is applied.

According to Fig. 6A, the changes of the relative dielectric constant of the formed film is small with respect to the changes of the high-frequency power, and the relative dielectric constant of the formed film gradually reduces in proportion to the increase of the high-frequency power. The relative dielectric constant of the formed film was 2.65 at the high-frequency power of 340W and 2.5 at 700W. The low value of the relative dielectric constant of 2.6 or less was obtained in the range of 450W to 700W.

### (b) Relationship between the high-frequency power (frequency: 13.56 MHz) and the dielectric breakdown field of the formed film

Fig. 6B is the view showing the relationship between the high-frequency power and the dielectric breakdown field of the formed film. The axis of ordinate denotes the dielectric breakdown field (MV/cm) of the formed film expressed in linear scale, and the axis of abscissas denotes the gas pressure (Torr) expressed in linear scale.

According to Fig. 6B, the changes of the dielectric breakdown field of the formed film were substantially fixed with respect to the changes of the high-frequency power. The dielectric breakdown field of the formed film was about 5.5 to 6MV/cm.

As described above, the field became 5MV/cm or more in the total survey range of the high-frequency from 340W to 700W. It was made clear that the film had sufficient dielectric breakdown voltage as the barrier insulating film.

### (c) Relationship between the high-frequency power (frequency: 13.56 MHz) and the deposition rate of the formed film.

Fig. 6C is the view showing the relationship between the high-frequency power and the deposition rate of the formed film. The axis of ordinate denotes the deposition rate (nm/min) expressed in linear scale, and the axis of abscissas denotes the high-frequency power (W) expressed in linear scale.

According to Fig. 6C, the deposition rate increases substantially in proportion to the increase of the high-frequency power. The deposition rate was 40nm/min at the high-frequency power of 340W and about 330nm/min at 1000 sccm.

Next, a silicon oxide film was deposited on the Si substrate by the plasma enhanced CVD method (PECVD method) under the following deposition condition II. In the deposition gas, DMTMDSO that is the chain siloxane having methoxy group was used as the second silicon containing organic compound. The deposition experiment result is shown below.

### Deposition condition II

Deposition gas
   OMCTS flow rate: 75 sccm
   HMTMDSO flow rate: 75 sccm
   H₂O flow rate: 500 sccm
   He flow rate: 100 sccm
   Gas pressure: 1.7 Torr
Plasma excitation condition
   Upper electrode (fist electrode)
      High-frequency power (frequency: 13.56 MHz): 562W (equivalent to about 0.6W/cm²)
   Lower electrode (second electrode)
      Low-frequency power (380 KHz): 0W
Substrate heating condition: 350°C

Figs. 7A to 7C show the result of data acquisition where the deposition condition other than the H₂O flow rate were fixed as the deposition condition II and the H₂O flow rate was changed in the range of 200 to 100 sccm. Further, Figs. 8A to 8C show the result of data acquisition where the deposition condition other than the gas pressure were fixed as the deposition condition II and the gas pressure was changed in the range of 1.0 to 2.0 Torr.

### (v) Relationship between the H₂O flow rate of deposition gas and the relative dielectric constant, the dielectric breakdown field and the deposition rate of an insulating film formed on an Si substrate

### (a) Relationship between the H₂O flow rate of deposition gas and the relative dielectric constant of the formed film

Fig. 7A is the view showing the relationship between the H₂O flow rate of deposition gas and the relative dielectric constant and the refraction index of the formed film. The left axis of ordinate denotes the relative dielectric constant of the formed film expressed in linear scale, the right axis of ordinate denotes the refraction index of the formed film expressed in linear scale, and the axis of abscissas denotes the H₂O flow rate (sccm) expressed in linear scale.

According to Fig. 7A, the relative dielectric constant of the formed film gradually reduces corresponding to the changes of the H₂O flow rate. The relative dielectric constant that was about 2.7 at the H₂O flow rate of 200 sccm became 2.5 at the H₂O flow rate of 1000 sccm. The low value of the relative dielectric constant of 2.6 or less was obtained in the range of the H₂O flow rate from about 300 to 1000 sccm.

### (b) Relationship between the H₂O flow rate of deposition gas and the dielectric breakdown field of the formed film

Fig. 7B is the view showing the relationship between the H₂O flow rate of deposition gas and the dielectric breakdown field of the formed film. The axis of ordinate shows the dielectric breakdown field (MV/cm) of the formed film expressed in linear scale, and the axis or abscissas shows the H₂O flow rate (sccm) expressed in linear scale.

According to Fig. 7B, a substantially constant value of 6MV/cm was obtained in the total survey range of the H₂O flow rate from 200 to 1000 sccm. It was made clear that the film had sufficient dielectric breakdown voltage as the barrier insulating film.

### (c) Relationship between the H₂O flow rate of deposition gas and the deposition rate of the formed film

Fig. 7C is the view showing the relationship between the H₂O flow rate of the deposition gas and the deposition rate of the formed film. The axis of ordinate shows the deposition rate (nm/min) of the formed film expressed in linear scale, and the axis of abscissas shows the H₂O flow rate (sccm) expressed in linear scale.

According to Fig. 7C, the deposition rate increases substantially in proportion to the increase of the H₂O flow rate. The deposition rate was 40nm/min at the H₂O flow rate of 200 sccm, and it was about 520nm/min at 1000 sccm. It was found out that a practical level was at a large H₂O flow rate.

### (vi) Relationship between the gas pressure of deposition gas and the relative dielectric constant, the dielectric breakdown field and the deposition rate of an insulating film formed on an Si substrate

### (a) Relationship between the gas pressure of deposition gas and the relative dielectric constant of the formed film

Fig. 8A is the view showing the relationship between the gas pressure of deposition gas and the relative dielectric constant and the refraction index of the formed film. The left axis of ordinate denotes the relative dielectric constant of the formed film expressed in linear scale, the right axis of ordinate denotes the refraction index of the formed film expressed in linear scale, and the axis of abscissas denotes the gas pressure (Torr) expressed in linear scale.

According to Fig. 8A, the changes of the relative dielectric constant of the formed film is small with respect to the changes of the gas pressure, and the relative dielectric constant of the formed film gradually reduces in proportion to the increase of the gas pressure. The relative dielectric constant of the formed film was 2.7 at the gas pressure of 1.0 Torr and 2.6 or less at the pressure of 2.0 Torr. The low value of the relative dielectric constant of 2.6 or less was obtained in the range of the gas pressure from 1.6 to 2.0 Torr.

### (b) Relationship between the gas pressure of deposition gas and the dielectric breakdown field of the formed film

Fig. 8B is the view showing the relationship between the gas pressure of the deposition gas and the dielectric breakdown field of the formed film. The axis of ordinate shows the dielectric breakdown field (MV/cm) of the formed film expressed in linear scale, and the axis or abscissas shows the gas pressure (Torr) expressed in linear scale.

According to Fig. 8B, the dielectric breakdown field of the formed film gradually reduces substantially in inverse proportion to the increase of the gas pressure. The dielectric breakdown field of the formed film was 6.2MV/cm at the gas pressure of 1.0 Torr and about 5.2MV/cm at the pressure of 2.0 Torr. As described above, 5 MV/cm was obtained in the total survey range of the gas pressure from 1.0 to 2.0 Torr. It was made clear that the film had sufficient dielectric breakdown voltage as the barrier insulating film.

### (c) Relationship between the gas pressure of deposition gas and the deposition rate of the formed film

Fig. 8C is the view showing the relationship between the gas pressure of the deposition gas and the deposition rate of the formed film. The axis of ordinate shows the deposition rate (nm/min) of the formed film expressed in linear scale, and the axis or abscissas shows the gas pressure (Torr) expressed in linear scale.

According to Fig. 8C, the deposition rate of the formed film increase substantially in proportion to the increase of the gas pressure. The deposition rate was 100nm/min at the gas pressure of 1.0 Torr and about 340nm/min at the pressure of 2.0 Torr.

### (d) Others

In the deposition under the deposition condition II, unlike the deposition under the deposition condition I, DMTMDSO containing methoxy group is used as the second silicon containing compound, so that the mechanical strength of the formed film can be further increased. This is considered to be caused by the behavior of oxygen contained in the methoxy group.

As described above, according to the first embodiment, deposition is performed by a plasma-enhanced CVD method using the deposition gas, which contains OMCTS (cyclic siloxane) having methyl group and HMDSO having methyl group or DMTMDSO (chain siloxane) having methoxy group as the silicon containing compound, and thus the white turbidity of the insulating film to be formed can be prevented to increase the mechanical strength, the absorbing characteristic can be improved, and the relative dielectric constant of 2.6 or less can be maintained.

The present invention has been explained above in detail based on the first embodiment, but the scope of the invention is not limited to the examples specifically shown in the above-described embodiment, and modifications of the above-described embodiment within a scope without departing from the gist of the invention are incorporated in the scope of the present invention.

For example, the ratio of the flow rate of the second silicon containing compound to the flow rate of the first silicon containing compound is set to 1:1 in the first embodiment, but the ratio can be appropriately changed. In this case, when its ratio is made smaller, the ratio of the first silicon containing compound relatively increases, and thus the relative dielectric constant becomes small, but the white turbidity occurs. On the contrary, when its ratio is made larger, the ratio of the second silicon containing compound relatively increases, and thus the white turbidity does not occur and the mechanical strength increases, but the relative dielectric constant becomes larger. Therefore, it is preferable that the ratio be set to an appropriate range to prevent problems.

Further, other compound having siloxane bond described in the first embodiment or methyl silane (SiHₙ(CH₃)₄₋ₙ: n=0, 1, 2, 3) can be used instead of HMDSO and DMTMDSO that were used in the first embodiment. Since the first embodiment shows the examples of other compound having siloxane bond and methyl silane, they are omitted here.

Furthermore, the deposition gas may be one containing methyl alcohol (CH₃OH) or ethyl alcohol (C₂H₅OH).

Still further, inert gas containing either argon (Ar) or nitrogen (N₂) instead of helium (He) may be added as diluting gas to the deposition gas.

### (Second Embodiment)

Next, the semiconductor device and the method of manufacturing the device according to the second embodiment will be described referring to Figs. 9A to 9G.

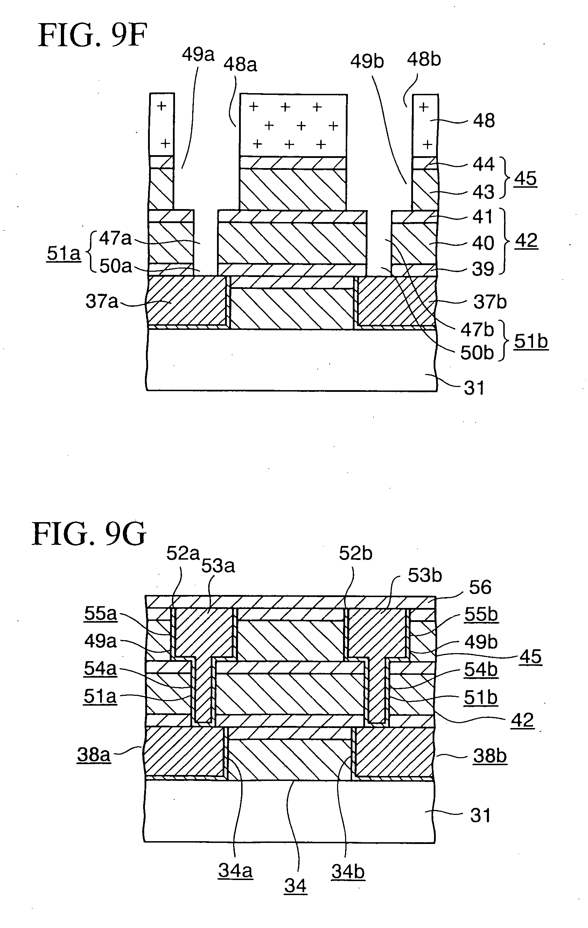

Fig. 9G is the sectional view showing the semiconductor device that has been fabricated by the method of manufacturing the semiconductor device according to the second embodiment of the present invention.

The semiconductor device has a dual damascene structure as shown in Fig. 9G. The device is made up of a lower wiring-buried insulating film 34 where lower wirings (38a, 38b) are buried, an upper wiring-buried insulating film 45 where upper wirings (55a, 55b) are buried, and a wiring interlayer insulating film 42 being sandwiched therebetween, where are laminated on a substrate 31. In the wiring interlayer insulating film 42, connecting conductors (54a, 54b) that connect the lower wirings (38a, 38b) with the upper wirings (55a, 55b) are buried. The lower wirings (38a, 38b), the connecting conductors (54a, 54b), and the upper wirings (55a, 55b) are mainly made of copper film. The lower wiring-buried insulating film 34 is made up of a primary insulating film and a barrier insulating film thereon, the wiring interlayer insulating film 42 is made up of a lower barrier insulating, film, a primary insulating film, and an upper barrier insulating film, and the upper-wiring buried insulating film 45 is made up of a primary insulating film and a barrier insulating film thereon.

In this embodiment, the deposition condition I are applied for the deposition of each primary insulating film of the lower wiring-buried insulating film 34, the wiring interlayer insulating film 42, and the upper-wiring buried insulating film 45.

In the method of manufacturing the semiconductor device, the substrate 31 is carried into the chamber 1 of a deposition apparatus 101 first, and is held on a substrate holder 3. Subsequently, the substrate 31 is heated and maintained at the temperature of 350°C. Then, as shown in Fig. 9A, OMCTS, HMDSO, H₂O, and He are introduced into the chamber 1 of the plasma deposition apparatus 101 shown in Fig. 1 at the flow rate of 75 sccm, 75 sccm, 500 sccm, and 100 sccm, respectively, and the pressure is held at 1.7 Torr. Subsequently, high-frequency power of 562W (equivalent to about 0.6W/cm²) having the frequency of 13.56MHz is applied to the upper electrode 2. In this case, low-frequency power of 380kHz is not applied to the lower electrode 3.

Consequently, OMCTS, HMDSO, H₂O, and He are transformed into plasma. This state is held for a predetermined period of time to form a primary insulating film 32 made of SiOCH film having the film thickness of about 1µm, which constitutes the lower wiring-buried insulating film 34, on the substrate (substrate subject to deposition) 31. Note that the SiOCH film is an insulating film containing Si, O, C, and H therein.

Subsequently, a barrier insulating film 33 that constitutes the lower wiring-buried insulating film 34 is formed on the primary insulating film 32 by the plasma-enhanced CVD method. As the barrier insulating film 33, a silicon oxide film deposited by other deposition condition can be used representatively, and a silicon oxynitride film or a silicon nitride film can be also used. These films are a little higher in relative dielectric constant, but are higher in copper diffusion preventing function and mechanical strength. The same also applies to the barrier insulating film to be deposited as follows.

Next, as shown in Fig. 9B, after the lower wiring-buried insulating film 34 has been etched to form lower wiring grooves (34a, 34b), a TaN film as a copper diffusion preventing film is formed on the inner surface of the lower wiring grooves (34a, 34b) as shown in Fig. 9C. Then, after a copper seed layer (not shown) has been formed on the surface of the TaN film by a sputtering method, the copper film is buried by a plating method. Subsequently, the copper film and the TaN film that are protruded from the wiring grooves (34a, 34b) are polished by a CMP method (Chemical Mechanical Polishing method) to make the surface flat. Consequently, the lower wirings (38a, 38b) mainly made of copper film, which is made up of copper films (37a, 37b) and TaN films (36a, 36b), are formed.

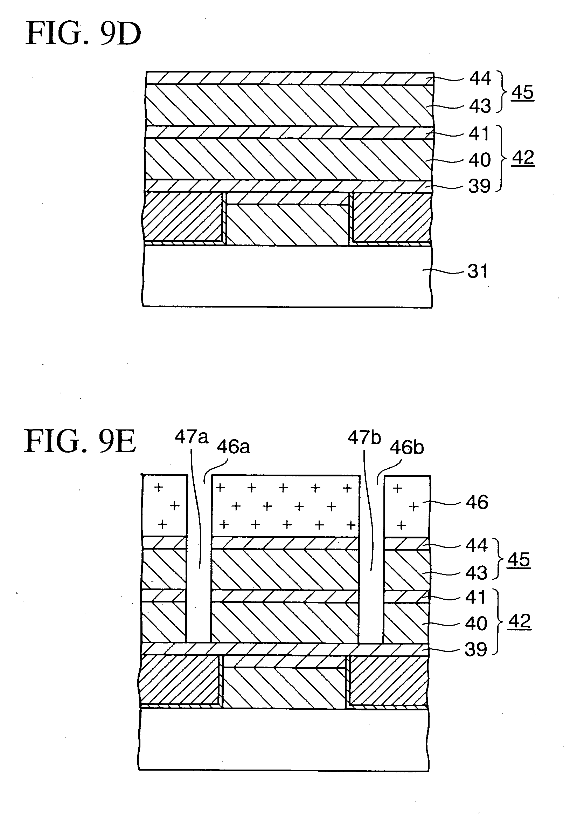

Next, as shown in Fig. 9D, the wiring interlayer insulating film 42 and the wiring-buried insulating film 45 are formed on the lower wiring-buried insulating film 34 shown in Fig. 9C. Its detail will be described as follows.

Specifically, to form the wiring interlayer insulating film 42, the substrate 31 shown in Fig. 9C is carried into the chamber 1 of the deposition apparatus 101 first, and held on the substrate holder 3. Subsequently, the substrate 31 is heated and maintained at the temperature of 350°C. The deposition gas is introduced into the chamber 1 to transform the gas into plasma, reaction is caused to form a barrier insulating film 39 having the film thickness of about 100nm, which contacts the lower wirings (38a, 38b) and covers the lower wirings (38a, 38b) and the lower wiring buried insulating film 34.

Next, a primary insulating film 40 made of SiOCH film having the film thickness of about 500nm is formed on the barrier insulating film 39 under the same deposition condition as the deposition condition of the primary insulating film 32 of Fig. 9A. Subsequently, a barrier insulating film 41 having the film thickness of about 100nm is formed on the primary insulating film 40 by the plasma-enhanced CVD method.

With the above process, the wiring interlayer insulating film 42 made up of the barrier insulating film 39, the primary insulating film 40, and the barrier insulating film 41 is formed.

Next, the upper wiring-buried insulating film 45 is formed on the wiring interlayer insulating film 42. Specifically, to form the upper wiring-buried insulating film 45, a primary insulating film 43 made of SiOCH film, which has low relative dielectric constant and the film thickness of about 500nm, is formed on the barrier insulating film 41 under the same deposition condition as the deposition condition of the primary insulating film 32 of Fig. 9A. Then, a barrier insulating film 44 having the film thickness of about 100nm is formed on the primary insulating film 43 by the plasma-enhanced CVD method.

With the above process, the upper wiring-buried insulating film 45 made up of the primary insulating film 43 and the barrier insulating film 44 is formed.

Next, description will be made for a method of forming the connecting conductors and the upper wirings that are mainly made of copper film, by a well-known dual damascene method.

Firstly, as shown in Fig.9E, a resist mask 46 having openings (46a, 46b) above the lower wirings (38a, 38b) is formed on the barrier insulating film 44, which constitutes the upper wiring-buried insulating film 45, by an exposure method. Subsequently, etching is sequentially performed to the barrier insulating film 44, the primary insulating film 43, the barrier insulating film 41, and the primary insulating film 40 through the openings (46a, 46b) to form openings (47a, 47b) reaching the barrier insulating film 39.

Next, as shown in Fig. 9F, after the resist mask 46 has been removed, a new resist mask 48 having openings (48a, 48b) is formed on the barrier insulating film 44 that constitutes the upper wiring-buried insulating film 45 by the exposure method. The openings (48a, 48b) of the resist mask 48 are formed so as to have wider opening width than the openings (47a, 47b) and include the openings (47a, 47b) inside thereof. Subsequently, the barrier insulating film 44 and the primary insulating film 43, which are exposed around the openings (47a, 47b) in the openings (48a, 48b), are sequentially etched through the openings (48a, 48b). When etching the barrier insulating film 44, the barrier insulating film 39 exposed at the bottom of the openings (47a, 47b), which have already been formed in the process of Fig. 9E, is also etched and the copper films (37a, 37b) that constitute the lower wirings (38a, 38b) appear at the bottom of the openings (47a, 47b). Note that reference numerals 50a and 50b in the drawing denote openings having the same shape and dimensions as the openings (47a, 47b). Consequently, openings (upper wiring grooves) (49a, 49b) having a wide opening width, which penetrate the upper wiring-buried insulating film 45, and openings (wiring connecting holes) (51a, 51b) having a narrow opening width, which connect with the openings (49a, 49b) and penetrate the wiring interlayer insulating film 42, are formed.

Next, as shown in Fig. 9G, a TaN film as the copper diffusion preventing film is formed on the inner surface of the wiring connecting holes (51a, 51b) and the upper wiring grooves (49a, 49b). Then, after a copper seed layer (not shown) has been formed on the surface of the TaN film by the sputtering method, the copper film is buried by the plating method. Subsequently, the copper film and the TaN film protruded from the upper wiring grooves (49a, 49b) are polished by the CMP method to make the surface flat. Thus, connecting conductors (54a, 54b) and upper wirings (55a, 55b), which are made up of copper films (53a, 53b) and TaN films (52a, 52b), are formed. Consequently, the lower wirings (38a, 38b) are connected with the upper wirings (55a, 55b) via the connecting conductors (54a, 54b).

Next, a barrier insulating film 56 is formed on the entire surface. Thus, the semiconductor device is completed.

As described above, according to the second embodiment, in the method of manufacturing the semiconductor device where the lower wiring-buried insulating film 34 in which the lower wirings (38a, 38b) are buried, the upper wiring-buried insulating film 45 in which the upper wirings (55a, 55b) are buried, and the wiring interlayer insulating film 42 sandwiched thereby are formed, each primary insulating film (32, 40, 43) of the lower wiring buried insulating film 34, the wiring interlayer insulating film 42, and the upper wiring buried insulating film 45 is deposited by the plasma-enhanced CVD method using deposition gas composing of gas mixture, where OMCTS (cyclic siloxane) having methyl group and HMDSO (chain siloxane) having methyl group are combined, and H₂O (oxidizing gas) and He (diluting gas) which are further added to the gas mixture.

Therefore, it is possible to prevent the white turbidity of the formed primary insulating film (32, 40, 43) to increase the mechanical strength, to improve the absorbing characteristics of the primary insulating film (32, 40, 43), and to maintain the relative dielectric constant of the primary insulating film (32, 40, 43) as low as 2.6 or less. Consequently, high-speed performance of the semiconductor device can be improved.

Further, by adding inert gas as the diluting gas to the above-described deposition gas, rapid reaction of deposition gas can be suppressed and vapor phase reaction can be suppressed. This prevents the reduction of the mechanical strength and adhesion strength of the formed film, and also prevents the generation of particles. Note that it is preferable to add an appropriate amount of the inert gas because too much addition of the inert gas results in increase of the relative dielectric constant.

The present invention has been explained above in detail based on the second embodiment, but the scope of the invention is not limited to the examples specifically shown in the above-described embodiment, and modifications of the above-described embodiment within a scope without departing from the gist of the invention are incorporated in the scope of the present invention.

For example, the deposition condition I are used as the deposition condition for the primary insulating films (32, 40, 43), but the deposition condition II or other deposition condition surveyed in the first embodiment may be used.

### (Third Embodiment)

Fig. 10 is the sectional view showing the semiconductor device being the third embodiment.

In Fig. 10, a different point from Fig. 9G is that the lower wiring-buried insulating film 34, the wiring interlayer insulating film 42, and the upper wiring-buried insulating film 45 do not include the barrier insulating films 33, 39, 41, 44, respectively, and those compose of only primary insulating films (61, 62, 63), respectively. Note that components in Fig. 10 shown by the same reference numerals as the reference numerals in Figs. 9A to 9G have the same functions as those of the components in Figs. 9A to 9G or denote the same components as the ones in Figs. 9A to 9G.

Next, the method of manufacturing the semiconductor device that is the third embodiment will be explained.

The semiconductor device shown in Fig. 12 of the third embodiment has a structure where the barrier insulating films have been removed respectively from the lower wiring-buried insulating film 34, the wiring interlayer insulating film 42, and the upper wiring buried insulating film 45 of the semiconductor device shown in Fig. 9G. For this reason, in the method of manufacturing the semiconductor device that is the third embodiment, the deposition process of the barrier insulating films is omitted from the manufacturing method of the second embodiment. In this case, the deposition condition I or the deposition condition II of the second embodiment, or other deposition condition surveyed in the first embodiment can be applied as the deposition condition of the insulating films (61, 62, 63). However, it is necessary that the film thickness of each insulating film (61, 62, 63) be a film thickness as required for the lower wiring-buried insulating film 34, the wiring interlayer insulating film 42, and the upper wiring-buried insulating film 45.

As described above, according to the third embodiment, in the method of manufacturing the semiconductor device for formation of the lower wiring-buried insulating film 34 in which the lower wirings (38a, 38b) are buried, the upper wiring buried insulating film 45 in which the upper wirings (55a, 55b) are buried, and the wiring interlayer insulating film 42 sandwiched between them, the single layer insulating films (61, 62, 63) constituting the lower wiring-buried insulating film 34, the wiring interlayer insulating film 42, and the upper wiring-buried insulating film 45 are deposited respectively by the plasma-enhanced CVD method using deposition gas that contains gas mixture where the cyclic siloxane having methyl group and the chain siloxane or organic silane having methyl group are combined as the silicon containing organic compound.

Therefore, it is possible to prevent the white turbidity of the formed primary insulating film (61, 62, 63) to increase the mechanical strength, to improve the absorbing characteristic of the formed films, and to maintain the relative dielectric constant of the primary insulating films (61, 62, 63) as low as 2.6 or less, similar to the first embodiment. Consequently, high-speed performance of the semiconductor device can be improved. Furthermore, since the formed insulating films (61, 62, 63) have the copper diffusion preventing function, they are primary insulating films having low dielectric constant and also serve as the barrier insulating films to copper.

Accordingly, only the single layer insulating films (61, 62, 63) are available as the lower wiring-buried insulating film 34, the wiring interlayer insulating film 42, and the upper wiring-buried insulating film 45, and thus the deposition of the barrier insulating films can be omitted. As a result, the manufacturing process can be simplified.

### (Fourth Embodiment)

Fig. 11 is the sectional view showing the semiconductor device being the fourth embodiment. Note that components in Fig. 11 shown by the same reference numerals as the reference numerals in Figs. 9A to 9G have the same functions as those of the components in Figs. 9A to 9G or denote the same components as the ones in Figs. 9A to 9G.

The semiconductor device being the fourth embodiment has the same laminated structure as the semiconductor device shown in Fig. 9G being the second embodiment. Specifically, the semiconductor device has the dual damascene structure as shown in Fig. 11, and the dual damascene structure is made up of the lower wiring-buried insulating film 34 in which the lower wirings (38a, 38b) are buried, the upper wiring-buried insulating film 45 in which the upper wirings (55a, 55b) are buried, and the wiring interlayer insulating film 42 being sandwiched therebetween, in which the connecting conductors (54a, 54b) for connecting the lower wirings (38a, 38b) with the upper wirings (55a, 55b) are buried, on the substrate 31. The lower wirings (38a, 38b), the connecting conductors (54a, 54b), and the upper wirings (55a, 55b) are mainly made of copper film. The lower wiring-buried insulating film 34 is made up of a primary insulating film 64 and a barrier insulating film 65 thereon, the wiring interlayer insulating film 42 is made up of a lower barrier insulating film 66, a primary insulating film 67, and an upper barrier insulating film 68, and the upper wiring-buried insulating film 45 is made up of a primary insulating film 69 and a barrier insulating film 70 thereon.

On the other hand, in the method of manufacturing the semiconductor device being the fourth embodiment, the deposition condition I, the deposition condition II of this embodiment or other deposition condition surveyed in the first embodiment are used for the deposition of respective barrier insulating films (65, 66, 68, 70, 71) that severally belong to the lower wiring-buried insulating film 34, the wiring interlayer insulating film 42, and the upper wiring-buried insulating film 45, unlike the second embodiment. In this case, insulating films having much lower dielectric constant can be used as the primary insulating films (64, 67, 69). For example, a porous insulating film formed by a series of processes of the deposition of the CVD method and post-treatment such as heating where the formed film is transformed into porous, or a coating insulating film formed by a coating method can be used.

As described above, in the method of manufacturing the semiconductor device for forming the lower wiring-buried insulating film 34, the upper wiring-buried insulating film 45, and the wiring interlayer insulating film 42 sandwiched between them, respective barrier insulating films (65, 66, 68, 70, 71) constituting the lower wiring buried insulating film 34, the wiring interlayer insulating film 42, and the upper wiring buried insulating film 45 are deposited by the plasma-enhanced CVD method using deposition gas that contains gas mixture where the cyclic siloxane having methyl group and the chain siloxane or organic silane having methyl group are combined as the silicon containing organic compound.

Therefore, as described in the first embodiment, it is possible to maintain the relative dielectric constant at 2.6 or less while respective barrier insulating films (65, 66, 68, 70, 71) constituting the lower wiring-buried insulating film 34, the wiring interlayer insulating film 42, and the upper wiring-buried insulating film 45 are allowed to have the copper diffusion preventing function. Thus, by using an insulating film having even lower relative dielectric constant for the primary insulating films as well, the primary insulating films can lead to further reducing the relative dielectric constant of the lower wiring-buried insulating film 34, the wiring interlayer insulating film 42, and the upper wiring-buried insulating film 45. Consequently, high-speed performance of the semiconductor device can be improved.

The present invention has been explained above in detail based on the fourth embodiment, but the scope of the invention is not limited to the examples specifically shown in the above-described embodiment, and modifications of the above-described embodiment within a scope without departing from the gist of the invention are incorporated in the scope of the present invention.

According to the present invention, by performing deposition by the plasma-enhanced CVD method using deposition gas having gas mixture as primary constituent gas, in which cyclic siloxane having at least one of methyl group and methoxy group is combined with chain siloxane having at least one of methyl group and methoxy group, deposition gas having gas mixture as primary constituent gas, in which cyclic siloxane having at least one of methyl group and methoxy group is combined with organic silane having at least one of methyl group and methoxy group, or deposition gas in which oxidizing gas such as H₂O is added to the gas mixture, the white turbidity of the insulating film to be formed is prevented to increase the mechanical strength, the absorbing characteristic is improved, and the relative dielectric constant of 2.6 or less can be maintained while the copper diffusion preventing function is maintained.

This deposition method is applied for the semiconductor device on which copper wirings and the like are formed, and the insulating films having the above-described property can be used as the barrier insulating film covering the copper wirings or the like, as the insulating film directly covering the copper wirings or the like, or as the primary insulating film on the barrier insulating film covering the copper wirings or the like. Furthermore, it is also possible to use the above-described insulating film, the barrier insulating film, and the primary insulating film as insulating films constituting the wiring interlayer insulating film or the wiring-buried insulating film.

With this method, the semiconductor device can follow the driving frequency exceeding GHz and the dimension of wiring pattern of 65nm or less without reducing the performance of the semiconductor device.

## Claims

1. A deposition method in which deposition gas is transformed into plasma and reaction is caused to form an insulating film having low dielectric constant, wherein
said deposition gas has a primary constituent gas composing of a first silicon containing compound having cyclic siloxane bond and at least one of methyl group and methoxy group, and a second silicon containing organic compound having chain siloxane bond and at least one of methyl group and methoxy group.

2. The deposition method according to claim 1, wherein
said primary constituent gas composing of oxidizing gas made up of one of H₂O, O₂, N₂O, and CO₂ in addition to the first silicon containing compound and the second silicon containing organic compound.

3. The deposition method according to claim 1, wherein
said primary constituent gas composing of alcohol in addition to said first silicon containing compound and said second silicon containing organic compound.

4. A deposition method according to claim 1, wherein
said primary constituent gas composing of oxidizing gas made up of one of H₂O, O₂, N₂O, and CO₂ and alcohol in addition to said first silicon containing compound and said second silicon containing organic compound.

5. A deposition method in which deposition gas is transformed into plasma and reaction is caused to form an insulating film having low dielectric constant, wherein
said deposition gas has a primary constituent gas composing of a first silicon containing compound having cyclic siloxane bond and at least one of methyl group and methoxy group, and organic silane where at least one of methyl group and methoxy group bonds with silicon.

6. A deposition method according to claim 5, wherein
said primary constituent gas composing of oxidizing gas made up of one of H₂O, O₂, N₂O, and CO₂ in addition to said first silicon containing compound and said organic silane.

7. The deposition method according to any one of claims 5 and 6, wherein
said organic silane is any one of

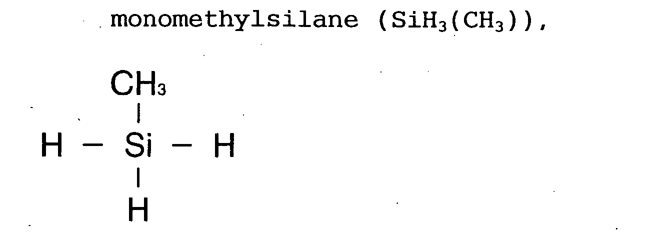

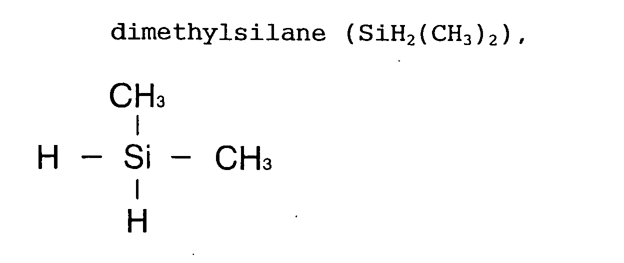

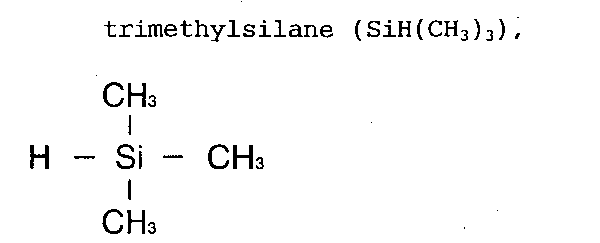

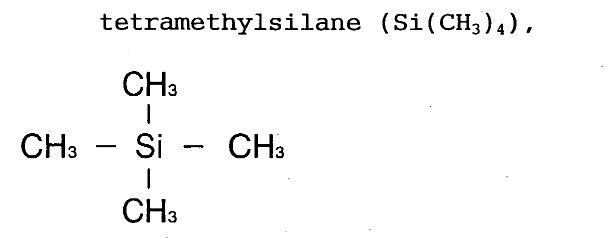

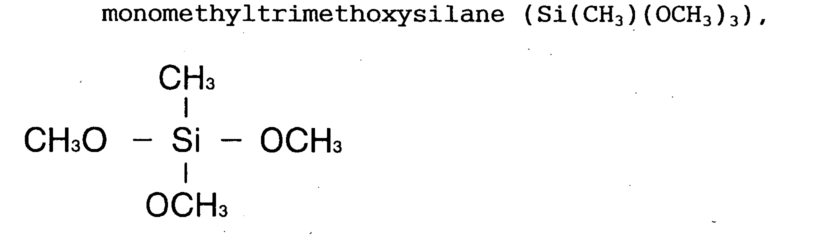

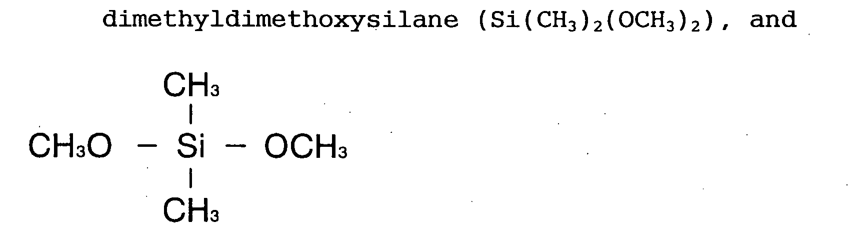

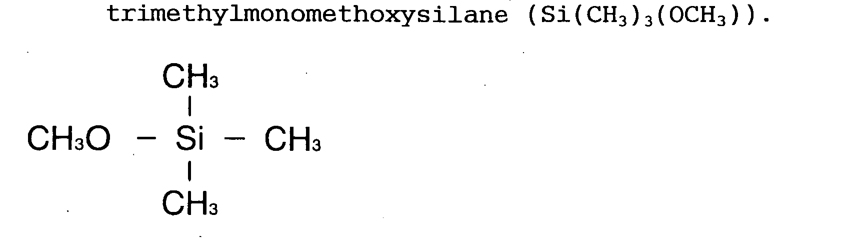

8. The deposition method according to any one of claims 1 to 7, wherein
said first silicon containing organic compound is any one of

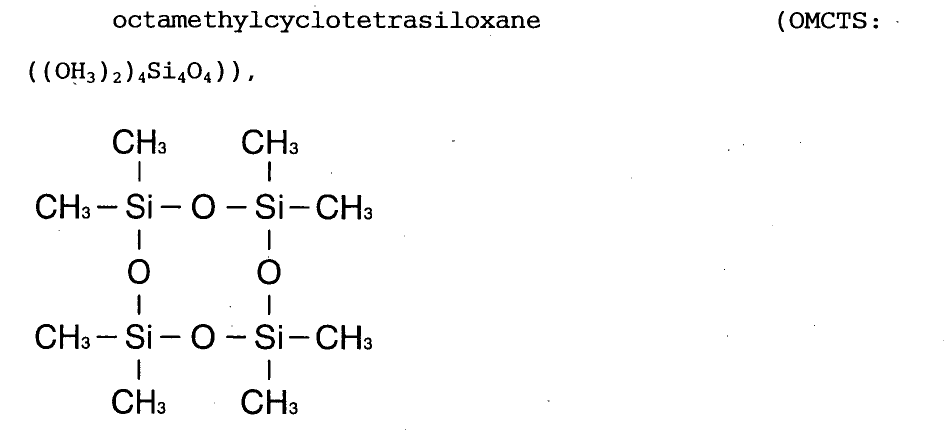

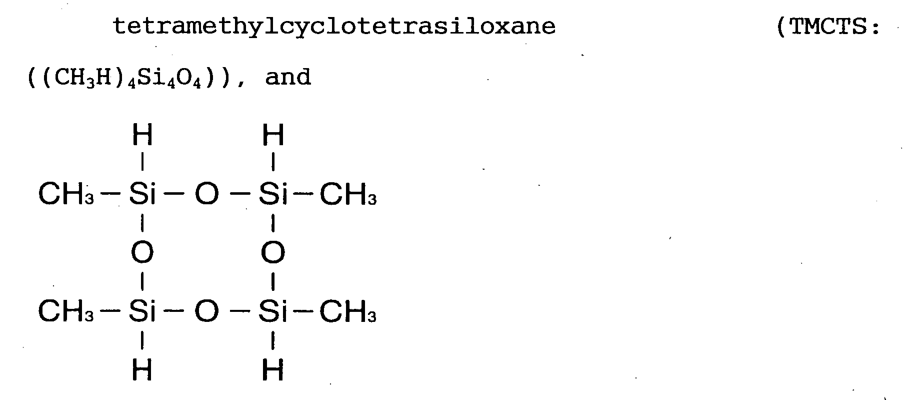

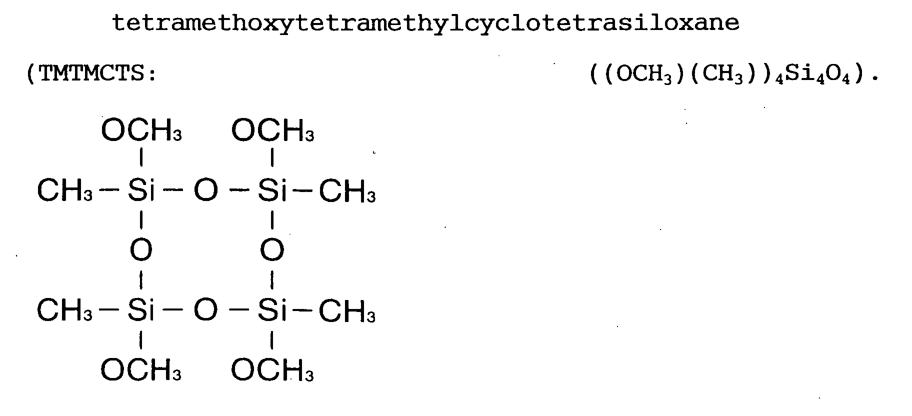

9. The deposition method according to any one of claims 1 to 4, wherein
said second silicon containing organic compound is any one of

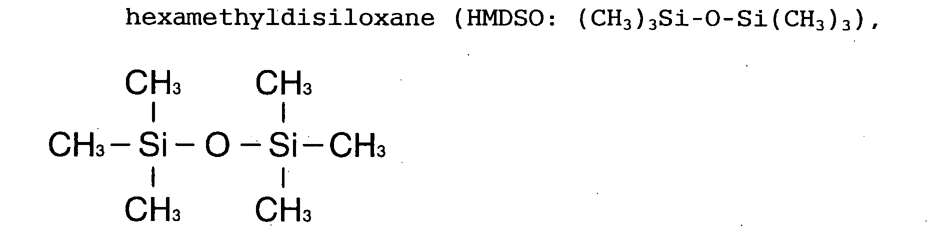

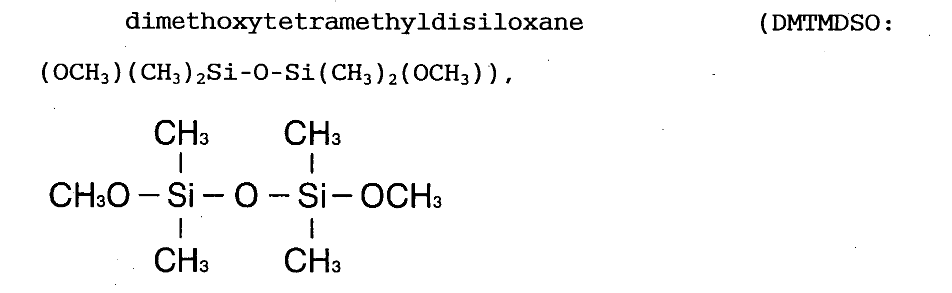

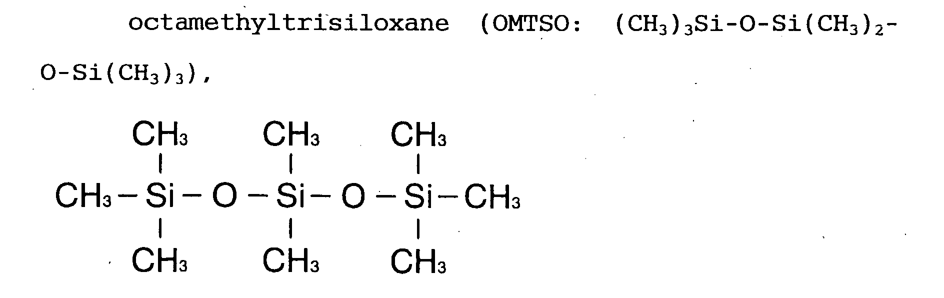

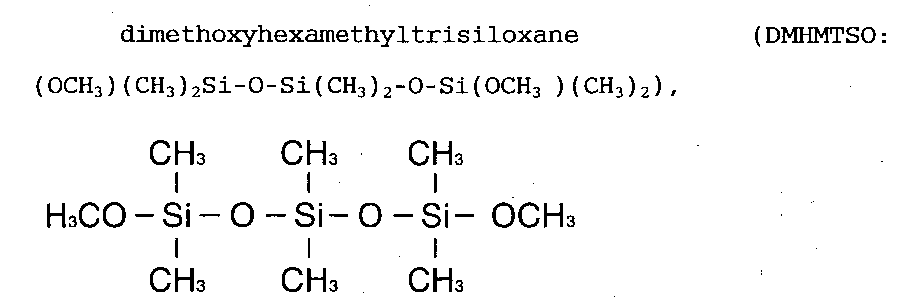

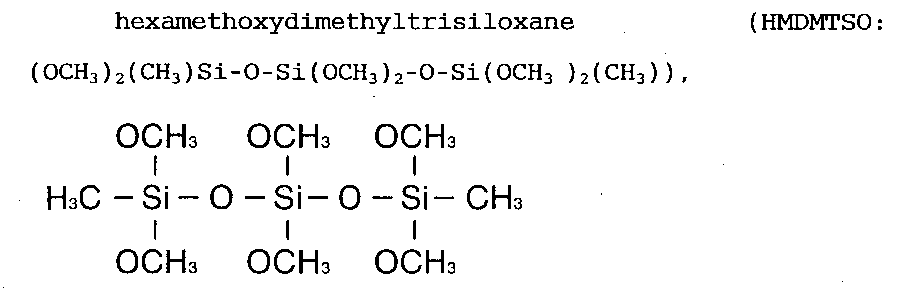

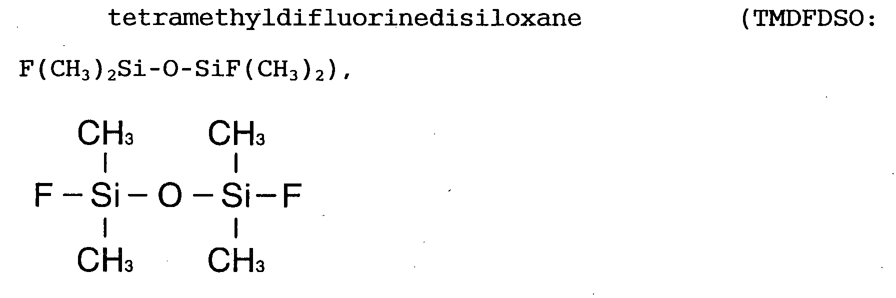

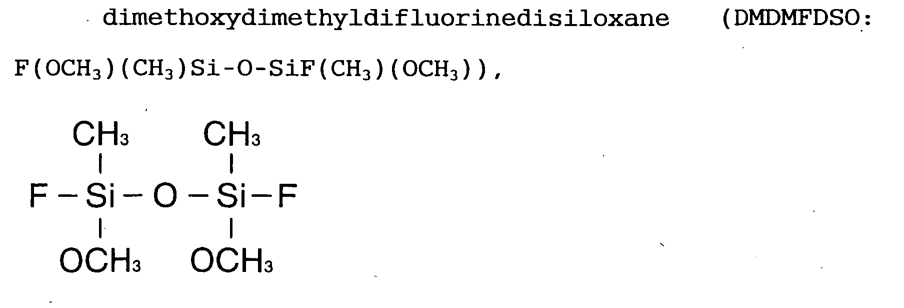

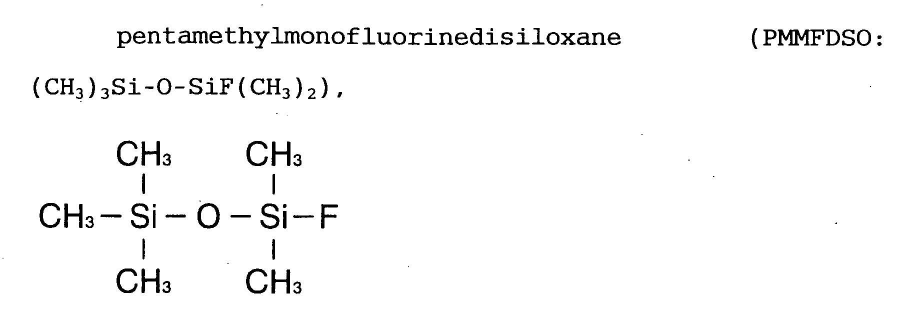

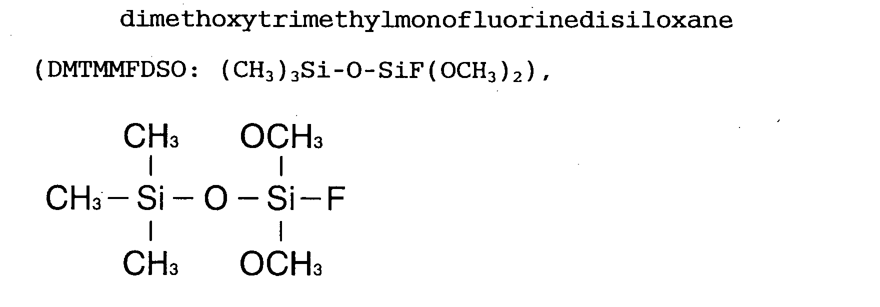

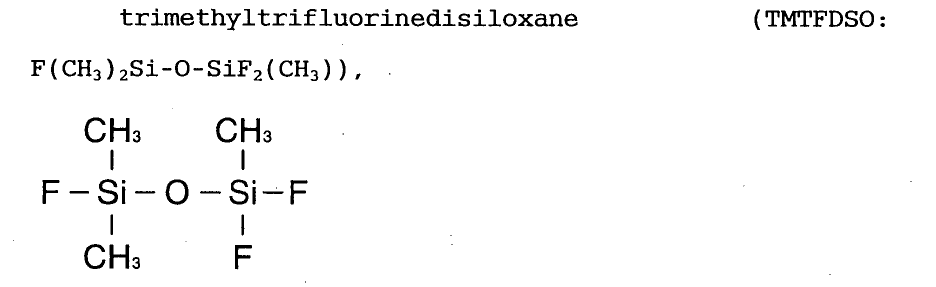

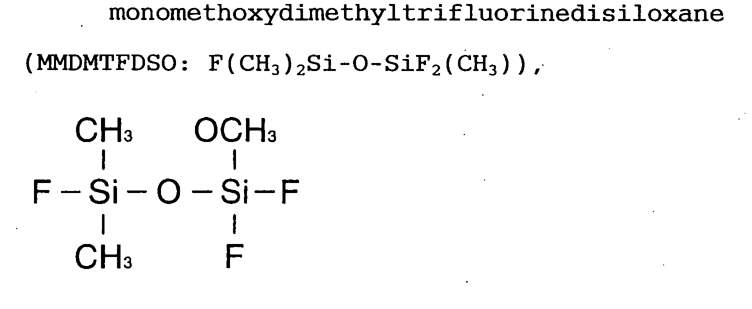

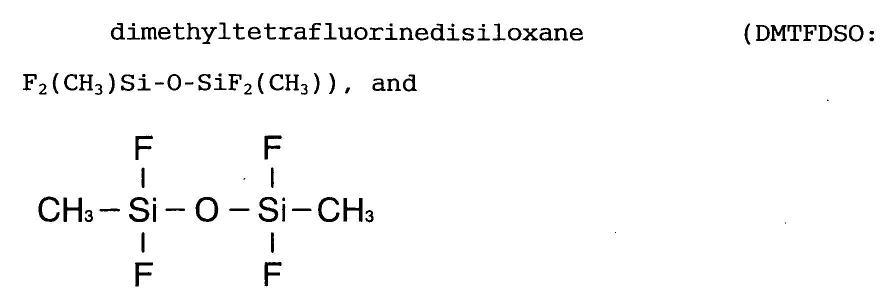

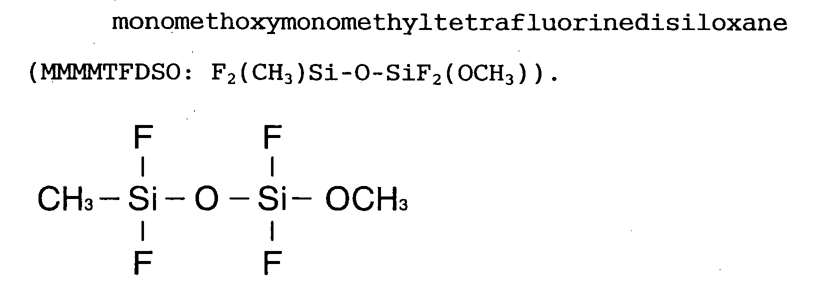

10. A semiconductor device where a wiring-buried insulating film, in which wirings mainly made of copper film is buried, is formed, wherein
said wiring-buried insulating film is made up of one layer of insulating film and is an insulating film having low dielectric constant, which is deposited by the deposition method according to any one claims 1 to 9.

11. A semiconductor device where a wiring-buried insulating film, in which wirings mainly made of copper film is buried, is formed, wherein
said wiring-buried insulating film is made up of at least two layers of a primary insulating film and a barrier insulating film on the primary insulating film, and any one of the insulating films is an insulating film having low dielectric constant, which is deposited by the deposition method according to any one claims 1 to 9.

12. A semiconductor device where an insulating film that contacts wirings mainly made of copper film is formed on the wirings mainly made of copper film, wherein
said insulating film is an insulating film having low dielectric constant, which is deposited by the deposition method according to any one claims 1 to 9.

13. The semiconductor device according to claim 12, wherein
said insulating film constitutes a wiring interlayer insulating film sandwiched by wirings mainly made of copper film.

14. A semiconductor device where at least a barrier insulating film, which contacts wirings mainly made of copper film, and a primary insulating film on the barrier insulating film are formed on the wirings mainly made of copper film, wherein
said barrier insulating film is an insulating film having low dielectric constant, which is deposited by the deposition method according to any one claims 1 to 9.

15. A semiconductor device where at least a barrier insulating film, which contacts wirings mainly made of copper film, and a primary insulating film on the barrier insulating film are formed on the wirings mainly made of copper film, wherein
said primary insulating film is an insulating film having low dielectric constant, which is deposited by the deposition method according to any one claims 1 to 9.

16. The semiconductor device according to any one of claims 14 and 15, wherein
the barrier insulating film, which contacts the wirings mainly made of copper film, and the primary insulating film on the barrier insulating film, which are formed on the wirings mainly made of said copper film, constitute a wiring interlayer insulating film sandwiched between the wirings mainly made of copper film.
